(19) Europäisches Patentamt
European Patent Office
Office européen des brevets

(11) **EP 4 438 766 A2**

(12) **EUROPEAN PATENT APPLICATION**

(43) Date of publication:
**02.10.2024 Bulletin 2024/40**

(51) International Patent Classification (IPC):
***C23C 14/04*** *(2006.01)* ***H10K 71/16*** *(2023.01)*

(21) Application number: **24160515.3**

(52) Cooperative Patent Classification (CPC):
**C23C 14/042; H10K 71/166**

(22) Date of filing: **29.02.2024**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **06.03.2023 KR 20230029362**

(71) Applicant: **Samsung Display Co., Ltd.**
**Yongin-si, Gyeonggi-do 17113 (KR)**

(72) Inventors:
• **KIM, Se Il**
  **Yongin-si (KR)**
• **YI, Sang Min**
  **Yongin-si (KR)**
• **LEE, Seung Jin**
  **Yongin-si (KR)**
• **CHUN, Ji Yun**
  **Yongin-si (KR)**

(74) Representative: **Marks & Clerk LLP**
**15 Fetter Lane**
**London EC4A 1BW (GB)**

(54) **MASK, MASK ASSEMBLY INCLUDING THE MASK, AND METHOD OF FABRICATING DISPLAY DEVICE**

(57) A mask includes, a plurality of rib portions (RP) disposed between a plurality of openings (OB), wherein the mask has a width in a first direction and a length in a second direction which intersects the first direction, the plurality of rib portions includes first rib portions (RP1), which are disposed between openings spaced apart from one another in the second direction among the plurality of openings, and second rib portions (RP2), which are disposed between openings to be spaced apart from one another in the first direction among the plurality of openings, sides of each of the first rib portions have a first taper angle, and the first taper angle is about 54 degrees or less.

**FIG. 10**

**Description**

BACKGROUND

1. Field

The disclosure relates to a mask, a mask assembly including the mask, and a method of fabricating a display device.

2. Description of the Related Art

Flat panel display devices such as a liquid crystal display ("LCD") and an organic light-emitting diode ("OLED") display are widely being used. A flat panel display device includes a metal layer having a predetermined pattern, and an OLED display forms an organic light-emitting layer having a predetermined pattern in each pixel. The metal layer and the organic light-emitting layer may be formed by a deposition method using a mask assembly.

The mask assembly includes a mask in which openings are defined to correspond to the pattern of the metal layer or the organic light-emitting layer and a mask frame which supports the mask. In a division mask method, the mask is divided into a plurality of division masks, which are stick-shaped, and the division masks are welded to the mask frame in a state of being stretched in a longitudinal direction. The division mask method is highly advantageous in that it may properly sort and use good products and may be easily repaired.

SUMMARY

Features of the disclosure provide a mask capable of improving a deposition shadow, a mask assembly including the mask, and a method of fabricating a display device.

However, features of the disclosure are not restricted to those set forth herein. The above and other features of the disclosure will become more apparent to one of ordinary skill in the art to which the disclosure pertains by referencing the detailed description of the disclosure given below.

In an embodiment of the disclosure, a mask includes a plurality of deposition pattern portions, and rib portions disposed between the plurality of deposition pattern portions, where a plurality of openings is defined in each of the plurality of deposition pattern portions, the mask has a width in a first direction and a length in a second direction which intersects the first direction, sides of each of openings that are parallel to the first direction, among the plurality of openings, have a first taper angle, and the first taper angle is about 54 degrees or less.

In an embodiment, the first taper angle is about 47 degrees or less.

In an embodiment, the mask has a first surface, a second surface, which is opposite to the first surface, a first side, which is extended to the first surface, and a second side, which is extended to the second surface, and the first and second sides are extended to each other.

In an embodiment, a diameter of the plurality of openings gradually decreases in a direction from the second surface to the first surface.

In an embodiment, sides of each of openings that are parallel to the second direction, among the plurality of openings, have a second taper angle, and the second taper angle is about 63 degrees or less.

In an embodiment, the second taper angle is about 60 degrees or less.

In an embodiment, the first and second taper angles are angles defined by an imaginary line, connecting points where the first and second sides meet and points where the second surface and the second side meet, and a plane, extended from the second surface.

In an embodiment of the disclosure, a mask includes a plurality of rib portions disposed between a plurality of openings, where the mask has a width in a first direction and a length in a second direction which intersects the first direction, the plurality of rib portions includes first rib portions, which are disposed between openings spaced apart from one another in the second direction among the plurality of openings, and second rib portions, which are disposed between openings spaced apart from one another in the first direction among the plurality of openings, sides of each of the first rib portions have a first taper angle, and the first taper angle is about 54 degrees or less.

In an embodiment, the first taper angle is about 47 degrees or less.

In an embodiment, sides of each of the second rib portions have a second taper angle, and the second taper angle is about 63 degrees or less.

In an embodiment, the second taper angle is about 60 degrees or less.

In an embodiment, each of the first rib portions and the second rib portions includes a first surface, a second surface, which is opposite to the first surface, a first side, which is extended to the first surface, and a second side, which is extended to the second surface, and the first and second sides are extended to each other.

In an embodiment, the first and second taper angles are angles defined by an imaginary line, connecting points where the first and second sides meet and points where the second surface and the second side meet, and a plane, extended from the second surface.

In an embodiment of the disclosure, a mask assembly includes a frame in which a frame opening is defined, and a plurality of masks disposed on the frame and covering the frame openings, where each of the plurality of masks includes a plurality of rib portions disposed between a plurality of openings, each of the masks has a width in a first direction and a length in a second direction which intersects the first direction, the rib portions include first rib portions, which are disposed between openings spaced apart from one another in the second direction among the plurality of openings, and second rib portions, which are disposed between openings spaced apart from one another in the first direction among the plurality of openings, sides of each of the first rib portions have a first taper angle, and the first taper angle is about 54 degrees or less.

In an embodiment, each of the masks further includes fixing portions, which overlap with the frame and are fixed to the frame, and the fixing portions are disposed at opposite ends, in a length direction, of a corresponding mask.

In an embodiment, the first taper angle is about 47 degrees or less.

In an embodiment, sides of each of the second rib portions have a second taper angle, and the second taper angle is about 63 degrees or less.

In an embodiment, the second taper angle is about 60 degrees or less.

In an embodiment, each of the first rib portions and the second rib portions includes a first surface, a second surface, which is opposite to the first surface, a first side, which is extended to the first surface, and a second side, which is extended to the second surface, and the first and second sides are extended to each other.

In an embodiment, the first and second taper angles are angles defined by an imaginary line, connecting points where the first and second sides meet and points where the second surface and the second side meet, and a plane, extended from the second surface.

In an embodiment of the disclosure, a method of fabricating a display device, includes fabricating first, second, and third mask assemblies where each of the first, second, and third mask assemblies includes masks, forming first light-emitting layers on a target substrate using the first mask assembly, forming second light-emitting layers on the target substrate using the second mask assembly, and forming third light-emitting layers on the target substrate using the third mask assembly, where each of the first, second, and third mask assemblies includes masks, each of the masks includes a plurality of rib portions disposed between a plurality of openings, each of the masks has a width in a first direction and a length in a second direction which intersects the first direction, the rib portions include first rib portions, which are disposed between openings spaced apart from one another in the second direction among the plurality of openings, and second rib portions, which are disposed between openings spaced apart from one another in the first direction among the plurality of openings, sides of each of the first rib portions have a first taper angle, and the first taper angle is about 54 degrees or less.

In an embodiment, the target substrate includes first emission areas, in which the first light-emitting layers are formed, second emission areas, in which the second light-emitting layers are formed, and third emission areas, in which the third light-emitting layers are formed, the first light-emitting layers emit blue light, the second light-emitting layers emit red light, and the third light-emitting layers emit green light.

In an embodiment, the first emission areas are repeatedly arranged and spaced apart from one another in the first direction, and the second emission areas and the third emission areas are disposed in the second direction with respect to the first emission areas and are alternately arranged in the first direction.

In an embodiment, the second emission areas and the third emission areas overlap with the first emission areas in the second direction, in a plan view.

In an embodiment, at least two of the second emission areas and at least two of the third emission areas overlap with one of the first emission areas in the second direction, in a plan view.

In an embodiment, the first taper angle is about 47 degrees or less.

In an embodiment, sides of each of the second rib portions have a second taper angle, and the second taper angle is about 63 degrees or less.

In an embodiment, the second taper angle is about 60 degrees or less.

In an embodiment, each of the first rib portions and the second rib portions includes a first surface, a second surface, which is opposite to the first surface, a first side, which is extended to the first surface, and a second side, which is extended to the second surface, and the first and second sides are extended to each other.

In an embodiment, the first and second taper angles are angles defined by an imaginary line, connecting points where the first and second sides meet and points where the second surface and the second side meet, and a plane, extended from the second surface.

According to the aforementioned and other embodiments of the disclosure, by controlling the taper angle of openings of a mask, an irregular deposition of patterns that may be caused by a deposition shadow phenomenon may be prevented, and the deposition material may also be prevented from being deposited over a larger area than desired.

It should be noted that the effects of the disclosure are not limited to those described above, and other effects of the disclosure will be apparent from the following description.

At least some of the above and other features of the invention are set out in the claims.

BRIEF DESCRIPTION OF THE DRAWINGS

The above and other features and features of the disclosure will become more apparent by describing in detail embodiments thereof with reference to the attached drawings, in which:

FIG. 1 is a perspective view of an embodiment of a display device according to the disclosure;
FIG. 2 is a plan view of an embodiment of a display panel according to the disclosure;
FIG. 3 is an enlarged plan view of portion of the display panel of FIG. 2;
FIG. 4 is a cross-sectional view of the display panel of FIG. 2;
FIG. 5 is a cross-sectional view of an embodiment of deposition equipment according to the disclosure;
FIG. 6 is a perspective view of an embodiment of a mask assembly according to the disclosure;
FIG. 7 is a perspective view of an embodiment of a mask according to the disclosure;
FIG. 8 is a plan view of portion of an embodiment of a first mask according to the disclosure;
FIG. 9 is a plan view illustrating a deposition pattern portion of the first mask of FIG. 8;
FIG. 10 is a cross-sectional view taken along line Q1-Q1' of FIG. 9;
FIG. 11 is an enlarged cross-sectional view of portion of the first mask of FIG. 10;
FIG. 12 is a cross-sectional view taken along line Q2-Q2' of FIG. 9;
FIG. 13 is an enlarged cross-sectional view of portion of the first mask of FIG. 12;
FIG. 14 is a plan view of portion of an embodiment of a second mask according to the disclosure;
FIG. 15 is a plan view illustrating a deposition pattern portion of the second mask of FIG. 14;
FIG. 16 is a cross-sectional view taken along line Q3-Q3' of FIG. 15;
FIG. 17 is a cross-sectional view taken along line Q4-Q4' of FIG. 15;
FIG. 18 is a plan view of portion of an embodiment of a third mask according to the disclosure;
FIG. 19 is a plan view illustrating a deposition pattern portion of the third mask of FIG. 18;
FIG. 20 is a cross-sectional view taken along line Q5-Q5' of FIG. 19;
FIG. 21 is a cross-sectional view taken along line Q6-Q6' of FIG. 19;
FIG. 22 is a cross-sectional view, taken along line Q7-Q7' of FIG. 3, of another embodiment of a display panel according to the disclosure;
FIG. 23 is a plan view of another embodiment of a first mask according to the disclosure;
FIG. 24 is a cross-sectional view taken along lines Q8-Q8' and Q9-Q9' of FIG. 23;
FIG. 25 is an enlarged plan view of portion of another embodiment of a display panel according to the disclosure;
FIG. 26 is a plan view of another embodiment of a first mask according to the disclosure;
FIG. 27 is a plan view of another embodiment of a second mask according to the disclosure;
FIG. 28 is a plan view of another embodiment of a third mask according to the disclosure;
FIG. 29 is a cross-sectional view taken along lines Q10-Q10' and Q11-Q11' of FIG. 26;
FIG. 30 is a flowchart illustrating an embodiment of a method of fabricating a display device according to the disclosure; and
FIGS. 31 through 35 illustrate steps of the method of FIG. 30.

DETAILED DESCRIPTION

Embodiments of the disclosure will now be described more fully hereinafter with reference to the accompanying drawings, in which preferred embodiments of the disclosure are shown. This invention may, however, be embodied in different forms and should not be construed as limited to the embodiments set forth herein. Rather, these embodiments are provided so that this disclosure will be thorough and complete, and will filly convey the scope of the disclosure to those skilled in the art.

It will also be understood that when a layer is also referred to as being "on" another layer or substrate, it may be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the disclosure. Similarly, the second element could also be termed the first element.

Each of the features of the various embodiments of the disclosure may be combined or combined with each other, in part or in whole, and technically various interlocking and driving are possible. Each embodiment may be implemented independently of each other or may be implemented together in an association.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term such as "about" can mean within one or more standard deviations, or within ± 30%, 20%, 10%, 5% of the stated value, for example.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments of the disclosure will be described with reference to the attached drawings.

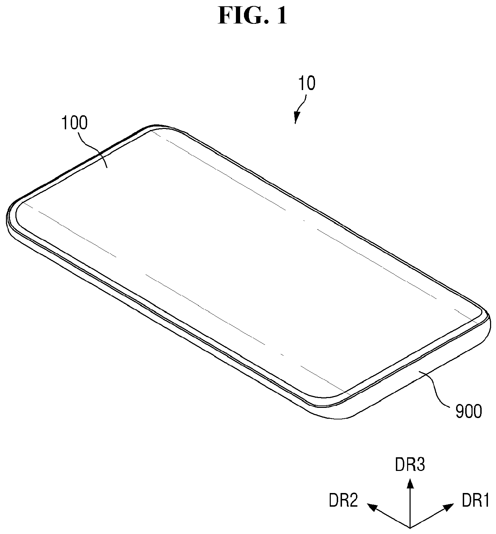

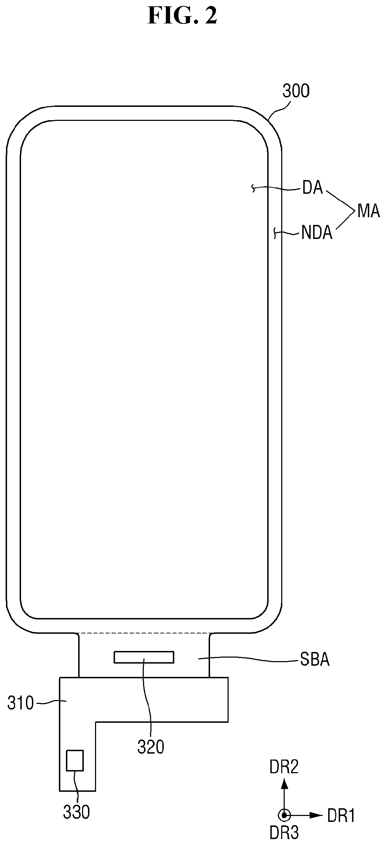

FIG. 1 is a perspective view of an embodiment of a display device according to the disclosure. FIG. 2 is a plan view of an embodiment of a display panel according to the disclosure.

Referring to FIGS. 1 and 2, a display device 10 may be applied to a portable electronic device such as a mobile phone, a smartphone, a tablet personal computer ("PC"), a mobile communication terminal, an electronic notepad, an electronic book ("e-book"), a portable multimedia player ("PMP"), a navigation device, or an ultra-mobile PC ("UMPC"). Also, the display device 10 may be applied as the display unit of a television ("TV"), a notebook computer, a monitor, a billboard, or an Internet-of-Things ("IoT") device. Also, the display device 10 may be applied to a wearable device such as a smartwatch, a watchphone, a glasses display, or a head-mounted display ("HMD"). Also, the display device 10 may be applied to the dashboard, the center fascia, or the center information display ("CID") of a vehicle, the room mirror display of a vehicle that may replace side-view mirrors, or an entertainment display disposed at the rear of the front seat of a vehicle.

A first direction DR1, which is the direction of the short sides of the display device 10, may be the horizontal or latitudinal direction of the display device 10, for example. A second direction DR2, which is the direction of the long sides of the display device 10, may be the vertical or longitudinal direction of the display device 10, for example. A third direction DR3 may be the thickness direction of the display device 10.

The display device 10 may have a quadrangle-like shape in a plan view. In an embodiment, the display device 10 may have a quadrangle-like shape having short sides extend in the first direction DR1 and long sides extending in the second direction DR2, in a plan view, for example. The corners where the short sides and the long sides of the display device 10 meet may be right-angled or may be rounded to have a predetermined curvature. The planar shape of the display device 10 is not particularly limited, and the display device 10 may have various other polygonal shapes, a circular shape, an elliptical shape, or the like. In an embodiment, the display device 10 may include a cover window 100 and a bottom cover 900.

The display device 10 may be flat. In an alternative embodiment, the display device 10 may include both opposing sides thereof curved. In an embodiment, the left and right sides of the display device 10 may be curved, for example. In an alternative embodiment, the upper, lower, left, and right sides of the display device 10 may all be curved.

The display device 10 may include a display panel 300. The display panel 300 may include a main area MA including a display area DA and a non-display area NDA.

The display area DA may include a pixel area, which includes pixels for displaying an image. The display panel 300 may be a light-emitting display panel including light-emitting elements. In an embodiment, the display panel 300 may be an organic light-emitting display panel using organic light-emitting diodes ("OLEDs"), which include organic light-emitting layers, a micro-light-emitting diode ("micro-LED") display panel using micro-LEDs, a quantum-dot light-emitting diode ("QLED") display panel using quantum-dot light-emitting layers, or an inorganic light-emitting display panel using inorganic light-emitting elements, which include an inorganic semiconductor, for example. The display panel 300 will hereinafter be described as being an organic light-emitting display panel.

A display circuit board 310 and a display driver circuit 320 may be attached to one side of the display panel 300. The display circuit board 310 may be a flexible printed circuit board ("FPCB") that may be bent, a rigid printed circuit board ("PCB") that is too rigid to be bent, or a hybrid PCB, which is the combination of an FPCB and a rigid PCB.

The display driver circuit 320 receives control signals and power supply voltages via the display circuit board 310, and generates and outputs signals and voltages for driving the display panel 300. In an embodiment, the display driver circuit 320 may be disposed on a subsidiary area SBA. The display driver circuit 320 may be formed as an integrated circuit ("IC") and may be attached on the display panel 300 in a chip-on-glass ("COG") or chip-on-plastic ("COP") manner, but the disclosure is not limited thereto. In an alternative embodiment, the display driver circuit 320 may be attached on the display circuit board 310.

A touch driver circuit 330 may be disposed on the display circuit board 310. The touch driver circuit 330 may be formed as an IC and may be attached on the top surface of the display circuit board 310. The touch driver circuit 330 may be electrically connected to touch electrodes of a touch sensor layer of the display panel 300 via the display circuit board 310. The touch driver circuit 330 may output touch driving signals to the touch electrodes and may detect the voltages that the capacitors of the touch electrodes are charged with. A power supply unit (not illustrated), which supplies display driving voltages for driving the display driver circuit 320, may be additionally disposed on the display circuit board 310.

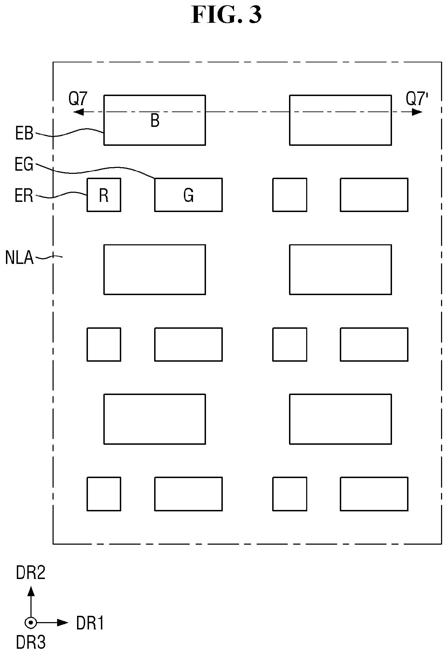

FIG. 3 is an enlarged plan view of portion of the display panel of FIG. 2.

Referring to FIG. 3, the display panel 300 may include a plurality of emission areas ER, EG, and EB and a non-emission area NLA. The emission areas ER, EG, and EB may be areas that emit light generated by light-emitting elements of the display panel 300, and the non-emission area NLA may be an area that does not emit light.

The emission areas ER, EG, and EB may include first emission areas ER, second emission areas EG, and third emission areas EB. The emission areas ER, EG, and EB may be classified into the first emission areas ER, the second emission areas EG, and the third emission areas EB, depending on the color of light emitted therefrom. In an embodiment, the first emission areas ER may emit first-color light, the second emission areas EG may emit second-color light, and the third emission areas EB may emit third-color light, for example. The first-color light may be red light, the second-color light may be green light, and the third-color light may be blue light.

The first emission areas ER, the second emission areas EG, and the third emission areas EB may be spaced apart from one another. In an embodiment, in a first row, the third emission areas EB may be spaced apart from one another in the first direction DR1, and in a second row, the first emission areas ER and the second emission areas EG may be alternately disposed in the first direction DR1, for example. First, second, and third emission areas ER, EG, and EB that are disposed adjacent to one another may function as a pixel.

The first emission areas ER, the second emission areas EG, and the third emission areas EB may have different sizes from each other. Here, the term "size" refers to the size or area in a plan view. In an embodiment, the third emission areas EB may be larger in size than the first emission areas ER and the second emission areas EG, the first emission areas ER may be smaller in size than the second emission areas EG and the third emission areas EB, and the second emission areas EG may be larger in size than the first emission areas ER and smaller in size than the third emission areas EB, for example. However, the disclosure is not limited thereto. The first emission areas ER, the second emission areas EG, and the third emission areas EB may all have the same size or may have different sizes from each other.

The first emission areas ER, the second emission areas EG, and the third emission areas EB may have a quadrilateral shape in a plan view. In an alternative embodiment, the first emission areas ER, the second emission areas EG, and the third emission areas EB may have a circular shape or a polygonal shape in a plan view. However, the disclosure is not limited thereto. The first emission areas ER, the second emission areas EG, and the third emission areas EB may all have the same shape or may have different shapes.

In each pixel, a third emission area EB may be disposed in the second direction DR2 with respect to first and second emission areas ER and EG. The length, in the first direction DR1, of the third emission areas EB may be greater than the lengths, in the first direction DR1, of the first emission areas ER and the second emission areas EG. The length, in the second direction DR2, of the third emission areas EB may be greater than the lengths, in the second direction DR2, of the first emission areas ER and the second emission areas EG. However, the disclosure is not limited thereto. The first emission areas ER, the second emission areas EG, and the third emission areas EB may all have the same length as each other or may have different lengths from each other.

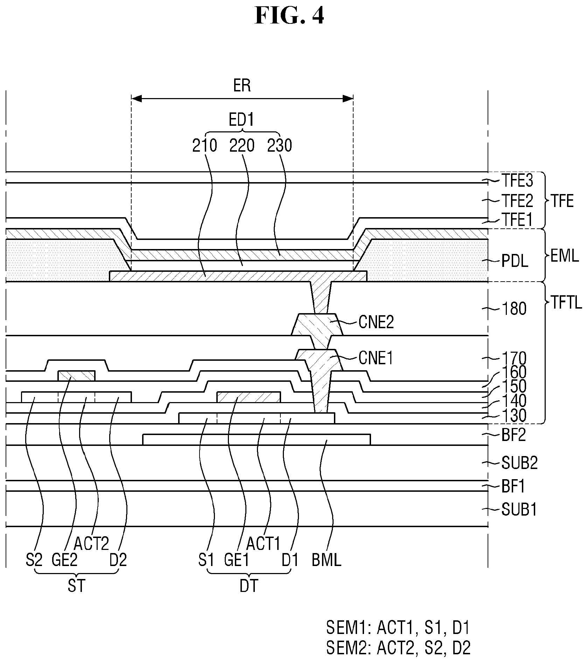

FIG. 4 is a cross-sectional view of the display panel of FIG. 2. FIG. 4 illustrates the cross-sectional structure of a first emission area ER of FIG. 3.

Referring to FIG. 4, a first buffer layer BF1 may be disposed on a first substrate SUB1, a second substrate SUB2 may be disposed on the first buffer layer BF1, and a second buffer layer BF2 may be disposed on the second substrate SUB2. A thin-film transistor ("TFT") layer TFTL, a light-emitting element layer EML, and an encapsulation layer TFE may be sequentially disposed on the second buffer layer BF2.

The first and second substrates SUB1 and SUB2 may include or consist of an insulating material such as glass, quartz, or a polymer resin. In an embodiment, the first and second substrates SUB1 and SUB2 may include polyimide, for example. The first and second substrates SUB1 and SUB2 may be flexible substrates that are bendable, foldable, or rollable.

The first and second buffer layers BF1 and BF2 are for protecting TFTs of the TFT layer and a light-emitting layer 220 of the light-emitting element layer EML from moisture from the first and second substrates SUB1 and SUB2, which are susceptible to moisture permeation. Each of the first and second buffer layers BF1 and BF2 may include a plurality of inorganic films that are alternately stacked. In an embodiment, each of the first and second buffer layers BF1 and BF2 may be formed as a multifilm in which at least one inorganic film selected from among a silicon nitride layer, a silicon oxynitride layer, a silicon oxide layer, a titanium oxide layer, and an aluminum oxide layer is alternately stacked, for example.

A light-blocking layer BML may be disposed on the second substrate SUB2. The light-blocking layer BML may overlap with a first active region ACT1 of a driving transistor DT to prevent a leakage current that may be generated in response to light being incident upon the first active region ACT1 of the driving transistor DT. FIG. 4 illustrates that the light-blocking layer BML overlaps only with the first active region ACT1 of the driving transistor DT, but the disclosure is not limited thereto. In an alternative embodiment, the light-blocking layer BML may also overlap with a second active region ACT2 of a switching transistor ST.

The light-blocking layer BML may be covered by the second buffer layer BF2. The light-blocking layer BML may be formed as a single layer or a multilayer including any one of molybdenum (Mo), aluminum (Al), chromium (Cr), gold (Au), titanium (Ti), nickel (Ni), neodymium (Nd), and copper (Cu) or any alloys thereof.

The TFT layer TFTL may include the driving transistor DT, which includes a first semiconductor layer SEM1 and a first gate electrode GE1, the switching transistor ST, which includes a second semiconductor layer SEM2 and a second gate electrode GE2, a gate insulating layer 130, a first inter-insulating layer 140, a second inter-insulating layer 150, a third inter-insulating layer 160, a first via layer 170, a second via layer 180, a first connection electrode CNE1, and a second connection electrode CNE2.

The first semiconductor layer SEM1 may be disposed on the second buffer layer BF2. The first semiconductor layer SEM1 may include polycrystalline silicon, low-temperature polycrystalline silicon, amorphous silicon, or an oxide semiconductor. The first semiconductor layer SEM1 may include a first source region S1, the first active region ACT1, and a first drain region D1, which are formed by ion doping.

The gate insulating layer 130 may be disposed on the first semiconductor layer SEM1. The gate insulating layer 130 may be formed as an inorganic film such as a silicon nitride layer, a silicon oxynitride layer, a silicon oxide layer, a titanium oxide layer, or an aluminum oxide layer.

The first gate electrode GE1 may be disposed on the gate insulating layer 130. The first gate electrode GE1 may be the gate electrode of the driving transistor DT and may overlap with the first active region ACT1 of the first semiconductor layer SEM1. Although not specifically illustrated, the first gate electrode GE1 may include a scan line and an emission line, which are connected to each pixel. The first gate electrode GE1 may be formed as a single layer or a multilayer including any one of Mo, Al, Cr, Au, Ti, N, Nd, and Cu or any alloys thereof.

The first inter-insulating layer 140 may be disposed on the first gate electrode GE1. The first inter-insulating layer 140 may be formed as an inorganic film such as a silicon nitride layer, a silicon oxynitride layer, a silicon oxide layer, a titanium oxide layer, or an aluminum oxide layer. The first inter-insulating layer 140 may include a plurality of inorganic films.

The second semiconductor layer SEM2 may be disposed on the first inter-insulating layer 140. The second semiconductor layer SEM2 may be spaced apart from the driving transistor DT and not overlap with the driving transistor DT in the third direction DR3 (or a Z-axis direction). The second semiconductor layer SEM2 may include an oxide semiconductor. The second semiconductor layer SEM2 may include a second source region S2, the second active region ACT2, and a second drain region D2.

The second inter-insulating layer 150 may be disposed on the second semiconductor layer SEM2. The second inter-insulating layer 150 may be formed as an inorganic film such as a silicon nitride layer, a silicon oxynitride layer, a silicon oxide layer, a titanium oxide layer, or an aluminum oxide layer. The second inter-insulating layer 150 may include a plurality of inorganic films.

The second gate electrode GE2 may be disposed on the second inter-insulating layer 150. The second gate electrode GE2 may be the gate electrode of the switching transistor ST and may overlap with the second active region ACT2 of the second semiconductor layer SEM2. Although not specifically illustrated, the second gate electrode GE2 may include an initialization voltage line, which is connected to each pixel, or a capacitor electrode. The second gate electrode GE2 may be formed as a single layer or a multilayer including any one of Mo, Al, Cr, Au, Ti, N, Nd, and Cu or any alloys thereof.

The third inter-insulating layer 160 may be disposed on the second gate electrode GE2. The third inter-insulating layer 160 may be formed as an inorganic film such as a silicon nitride layer, a silicon oxynitride layer, a silicon oxide layer, a titanium oxide layer, or an aluminum oxide layer. The third inter-insulating layer 160 may include a plurality of inorganic films.

The first connection electrode CNE1 may be disposed on the third inter-insulating layer 160. The first connection electrode CNE1 may be connected to the first drain region D1 of the driving transistor DT through a contact hole penetrating the gate insulating layer 130, the first inter-insulating layer 140, the second inter-insulating layer 150, and the third inter-insulating layer 160. The first connection electrode CNE1 may be formed as a single layer or a multilayer including any one of Mo, Al, Cr, Au, Ti, N, Nd, and Cu or any alloys thereof.

The first via layer 170 may be disposed on the first connection electrode CNE1. The first via layer 170 may planarize step differences formed by the underlying electrodes. The first via layer 170 may be formed as an organic film including an acrylic resin, an epoxy resin, a phenolic resin, a polyamide resin, or a polyimide resin.

The second connection electrode CNE2 may be disposed on the first via layer 170, and the second via layer 180 may be disposed on the second connection electrode CNE2. The second connection electrode CNE2 may be connected to the first connection electrode CNE1 through a contact hole penetrating the first via layer 170. The second connection electrode CNE2 may be formed as a single layer or a multilayer including any one of Mo, Al, Cr, Au, Ti, N, Nd, and Cu or any alloys thereof. The second via layer 180 may planarize a step difference formed by the second connection electrode CNE2 and may include the same material as that of the first via layer 170.

The light-emitting element layer EML may be disposed on the TFT layer TFTL. The light-emitting element layer EML may include a first light-emitting element ED1 and a bank PDL. The first light-emitting element ED1 and the bank PDL may be disposed on the second via layer 180. The first light-emitting element ED1 may include a first electrode 210, the light-emitting layer 220, and a second electrode 230.

The first electrode 210 may be disposed on the second via layer 180. The first electrode 210 may be connected to the second connection electrode CNE2 through a contact hole penetrating the second via layer 180. In a top emission structure that emits light in a direction from the light-emitting layer 220 to the second electrode 230, the first electrode 210 may include or consist of a metal material with relatively high reflectance such as a stack of Al and Ti (e.g., Ti/Al/Ti), a stack of Al and indium tin oxide ("ITO") (e.g., "ITO/A1/ITO"), a silver (Ag)-palladium (Pd)-copper (Cu) ("APC") alloy, or a stack of an APC alloy and ITO (e.g., "ITO/APC/ITO").

The bank PDL may partition the first electrode 210 on the second via layer 180 to define the first light-emitting area ER. The bank PDL may cover edges of the first electrode 210. The bank PDL may be formed as an organic film including an acrylic resin, an epoxy resin, a phenolic resin, a polyamide resin, or a polyimide resin. The bank PDL may display a black color. The bank PDL may include a dye or a pigment such as carbon black.

The first emission area ER is an area where the first electrode 210, the light-emitting layer 220, and the second electrode 230 are sequentially stacked so that holes from the first electrode 210 and electrons from the second electrode 230 combine together in the light-emitting layer 220 to emit light.

The light-emitting layer 220 may be disposed on the first electrode 210 and the bank PDL. The light-emitting layer 220 may include an organic material and may emit light of a particular color. In an embodiment, the light-emitting layer 220 may include a hole transport layer, an organic material layer, and an electron transport layer, for example. The light-emitting layer 220 may further include a hole injection layer, an electron injection layer, and a charge generation layer.

The second electrode 230 may be disposed on the light-emitting layer 220. The second electrode 230 may cover the light-emitting layer 220. The second electrode 230 may be a common layer formed in common in all pixels. A capping layer may be further formed on the second electrode 230.

In the top emission structure, the second electrode 230 may include or consist of a transparent metal material capable of transmitting light therethrough, such as ITO or indium zinc oxide ("IZO"), or a semitransparent metal material such as magnesium (Mg), Ag, or any alloys thereof. When the second electrode 230 includes or consists of a semitransparent metal material, emission efficiency may be improved due to microcavities.

The encapsulation layer TFE may be disposed on the light-emitting element layer EML. The encapsulation layer TFE may include at least one inorganic film to prevent the permeation of oxygen or moisture into the light-emitting element layer EML. The encapsulation layer TFE may further include at least one organic film to protect the light-emitting element layer EML from a foreign material such as dust. In an embodiment, the encapsulation layer TFE may include a first inorganic film TFE1, an organic film TFE2, and a second inorganic film TFE3, for example.

The first inorganic film TFE1 may be disposed on the second electrode 230, the organic film TFE2 may be disposed on the first inorganic film TFE1, and the second inorganic film TFE3 may be disposed on the organic film TFE2. The first and second inorganic films TFE1 and TFE3 may be formed as multi-films in which at least one inorganic film selected from among a silicon nitride layer, a silicon oxynitride layer, a silicon oxide layer, a titanium oxide layer, and an aluminum oxide layer is alternately stacked. The organic film TFE2 may include a monomer.

The light-emitting layer 220 of the light-emitting element layer EML may be deposited by a deposition method using deposition equipment. The deposition method vaporizes an organic material, which is the material of the light-emitting layer 220, from a source to deposit the organic material onto a substrate, using a mask.

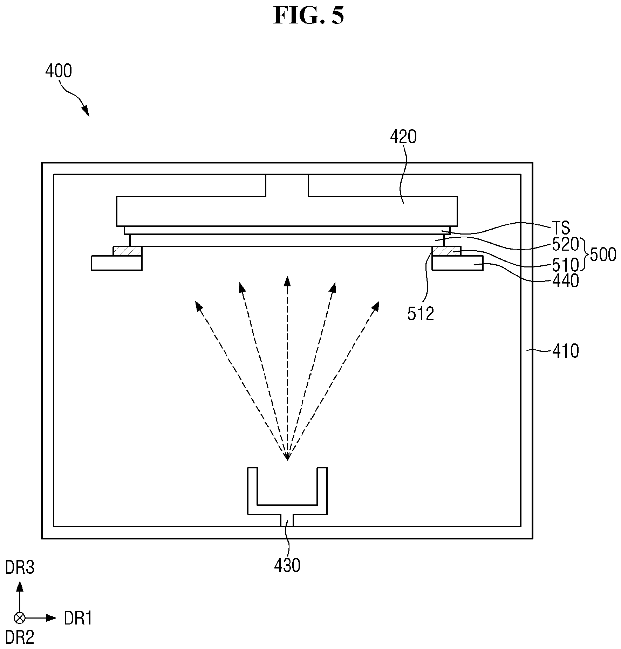

FIG. 5 is a cross-sectional view of an embodiment of deposition equipment according to the disclosure.

Referring to FIG. 5, deposition equipment 400 may include a deposition chamber 410, a fixing member 420, a deposition source 430, and a mask assembly 500.

The deposition chamber 410, which is space in which a deposition process is to be performed, may maintain a vacuum atmosphere. The deposition chamber 410 may have an enclosed shape.

The fixing member 420 may be disposed in the deposition chamber 410. The fixing member 420 may be disposed in an upper portion of the deposition chamber 410 to face the deposition source 430. Although not specifically illustrated, the fixing member 420 may be provided with a target substrate TS (such as a magnetic material or a plate) and the mask assembly 500.

The deposition source 430 may sublimate or vaporize a deposition material. The deposition material may be included in the deposition source 430 and may include at least one of a metal, an inorganic material, and an organic material. The deposition material may include an organic light-emitting material for forming the light-emitting layer 220. The deposition material may be ejected as vapor from the deposition source 430. The vapor may be deposited onto the target substrate TS through the mask assembly 500 as a pattern.

A stage 440 may be disposed in the deposition chamber 410, between the deposition source 430 and the mask assembly 500. The stage 440 may support the mask assembly 500. Although not specifically illustrated, the stage 440 may include a driver for moving the mask assembly 500 to align the mask assembly 500 and the target substrate TS. The stage 440 may be disposed not to interfere with the path of movement of the deposition material from the deposition source 430 to the target substrate TS.

The mask assembly 500 may be disposed on the stage 440, in the deposition chamber 410. The mask assembly 500 may include masks 520 and a frame 510. The mask assembly 500 will be described later.

The target substrate TS may be a glass substrate or a plastic substrate. The target substrate TS may be a substrate with layers, including up to the bank PDL, already formed thereon. That is, the target substrate TS may be a substrate that has already been subjected to processes followed by the formation of the light-emitting layer 220. The target substrate TS may be a mother substrate with multiple display panels formed thereon. That is, the mother substrate may be a substrate yet to be cut into the multiple display panels.

The mask assembly 500 will hereinafter be described.

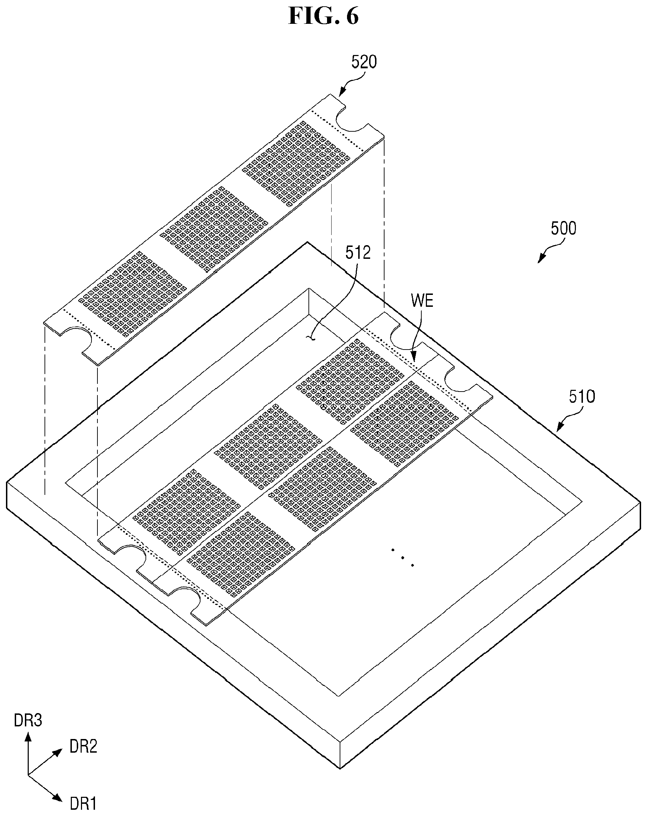

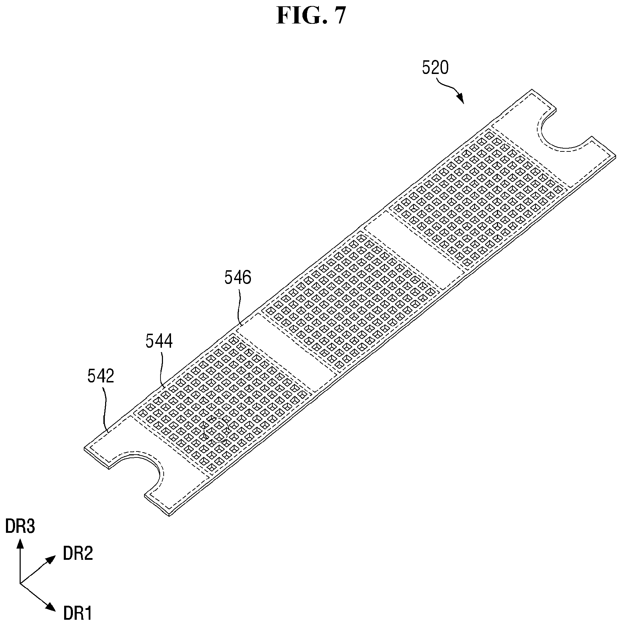

FIG. 6 is a perspective view of an embodiment of a mask assembly according to the disclosure. FIG. 7 is a perspective view of an embodiment of a mask according to the disclosure.

Referring to FIGS. 6 and 7, a mask assembly 500 includes a frame 510 and a plurality of masks 520, which are disposed on the frame 510.

The frame 510, which forms the outer frame of the mask assembly 500, may be a quadrilateral frame with a frame opening 512 defined in the middle. The frame 510 may have a predetermined thickness in the third direction DR3 to stably support the masks 520. The frame 510 may include a pair of long sides and a pair of short sides, and the frame opening 512 may be defined in the middle of the frame 510. In an embodiment, the long sides of the frame 510 may extend in the first direction DR1 and may be spaced apart from each other in the second direction DR2 to be parallel to each other, for example. The short sides of the frame 510 may extend in the second direction DR2 and may be spaced apart from each other in the first direction DR1 to be parallel to each other.

In a plan view, the frame opening 512 may have a quadrangular shape, e.g., rectangular shape. The frame opening 512 may provide a path for a deposition material to pass through. In some embodiments, the frame 510 may be a square frame having two pairs of sides that are equal in length and may have a square shape in a plan view. The frame 510 may include a material with relatively high rigidity such as a metal (e.g., stainless steel).

The masks 520 may be disposed on the frame 510. Each of the masks 520 may include a first surface (or a top surface) and a second surface (or a bottom surface). The first surface is a surface to contact a substrate (not illustrated) during a deposition process, and the second surface may be the surface opposite to the first surface one surface and may be a surface on which to provide the deposition material. The second surfaces of the masks 520 may contact the frame 510.

The length of the masks 520 (e.g., the length, in the second direction DR2, of the masks 520) may be greater than the width of the masks 520 (e.g., the length, in the first direction DR1, of the masks 520). The masks 520 may extend in the first direction DR1 and may be adjacent to one another in the second direction DR2. In an alternative embodiment, a single mask 520 that is relatively large enough to cover the frame opening 512 in a plan view may be provided. The masks 520 may be fine metal masks including or consisting of a metal material. The masks 520 may include or consist of a metal such as stainless steel, Ni, cobalt (Co), or any alloys thereof. In some embodiments, the masks 520 may exhibit magnetic properties.

Referring to FIG. 7, a mask 520 may include fixing portions 542, which are disposed at opposite ends, in a length direction (i.e., the second direction DR2), of the mask 520, a plurality of deposition pattern portions 544, which are disposed closer than the fixing portions 542 to the center of the mask 520, and rib portions 546, which are disposed between the deposition pattern portions 544.

The fixing portions 542 may be parts of the mask 520 that are to contact, and coupled to, the frame 510. In an embodiment, the fixing portions 542 may be welded to the frame 510, for example. The fixing portions 542 may be welded to the frame 510 via laser welding or resistance heating welding, but the disclosure is not limited thereto. The fixing portions 542 may include welded portions WE (see Figure 6), which are formed by welding the mask 520 to the frame 510. The welded portions WE may be formed as a plurality of spots in regions corresponding to the fixing portions 542. Each of the welded portions WE is illustrated as being arranged as a row of spots, but the disclosure is not limited thereto. In an alternative embodiment, each of the welded portions WE may be arranged as two or more rows of spots.

The deposition pattern portions 544 are parts of the mask 520 in which a plurality of openings for providing paths for a deposition material to pass through is defined. A plurality of deposition pattern portions 544 may be spaced apart from one another in the length direction of the mask 520 (i.e., the second direction DR2). Three deposition pattern portions 544 are illustrated as being spaced apart from one another in the second direction DR2, but the disclosure is not limited thereto.

Each of the deposition pattern portions 544 may correspond to a single display device (e.g., an organic light-emitting display device). In this case, patterns corresponding to multiple display devices may be deposited at the same time via a single process using a single mask assembly 500. That is, the mask assembly 500 may correspond to a single mother substrate, and patterns corresponding to multiple display devices may be formed on the mother substrate.

A plurality of openings may be defined in each of the deposition pattern portions 544. The openings penetrate both the first and second surfaces of the mask 520. The openings may expose deposition target regions of the target substrate TS. That is, the openings may have substantially the same shape as deposition patterns to be formed on the target substrate TS. The openings are illustrated as being spaced apart from one another in the first and second directions DR1 and DR2, having a dot shape in a plan view, and being arranged in a matrix, but the disclosure is not limited thereto.

The rib portions 546 may be disposed between the deposition pattern portions 544, which are adjacent to one another in the second direction DR2. The rib portions 546 may divide the deposition pattern portions 544 from one another. As no opening is defined in the rib portions 546, the rib portions 546 may block the transmission of the deposition material therethrough.

The mask 520 may be welded to the frame 510 while applying a tensile force in the length direction of the mask 520 (e.g., the second direction DR2). In order to form different light-emitting layers in different types of emission areas, i.e., in the first emission areas ER, second emission areas EG, and third emission areas EB of FIG. 3, multiple masks 520 may be provided. In an embodiment, light-emitting layers may be formed on the target substrate TS by depositing a deposition material on the target substrate TS using a first mask in which a plurality of openings that correspond to the first emission areas ER is defined, a second mask in which a plurality of openings that correspond to the second emission areas EG is defined, and a third mask in which a plurality of openings that correspond to the third emission areas EB is defined, for example.

Referring to FIG. 5, a deposition material may be vaporized from the deposition source 430 and may be deposited on the target substrate TS through the openings of each of the masks 520. The openings of each of the masks 520 may be designed to have a predetermined taper angle in consideration of the scattering angle of the deposition material. That is, as the deposition material is incident upon the masks 520 at a predetermined incidence angle, the taper angle of the openings of each of the masks 520 plays an important role in accurately depositing the deposition material at each desired location on the target substrate TS.

The masks 520 will hereinafter be described in further detail. The masks 520 may be classified into a first mask in which a plurality of openings that correspond to the first emission areas ER is defined, a second mask in which a plurality of openings that correspond to the second emission areas EG is defined, and a third mask in which a plurality of openings that correspond to the third emission areas EB is defined, and the first, second, and third masks will hereinafter be described. In the subsequent discussion, a first mask corresponds to a third emission area, a second mask corresponds to a first emission area and a third mask corresponds to a second emission area.

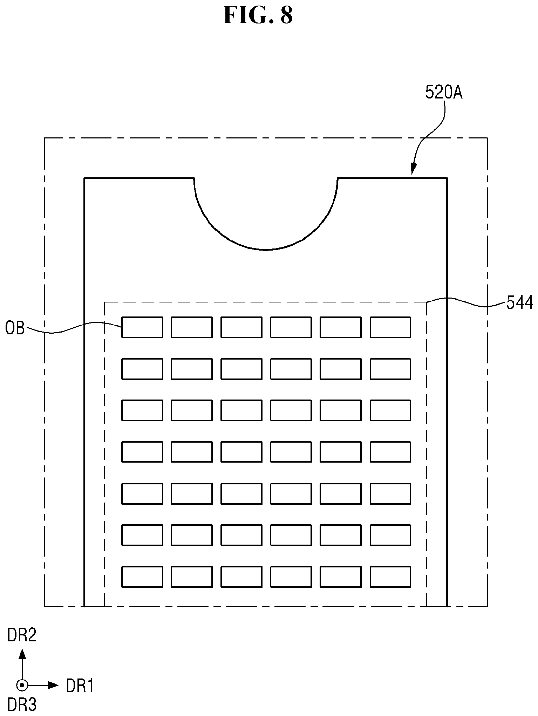

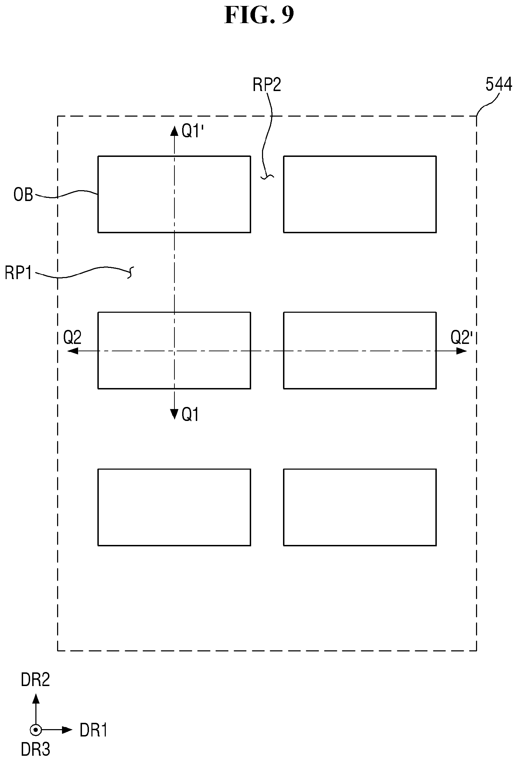

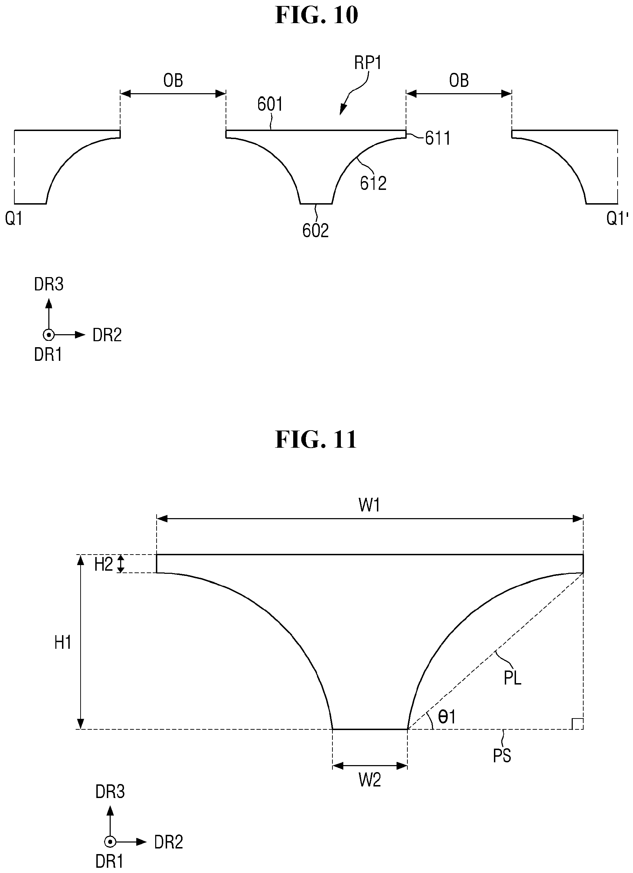

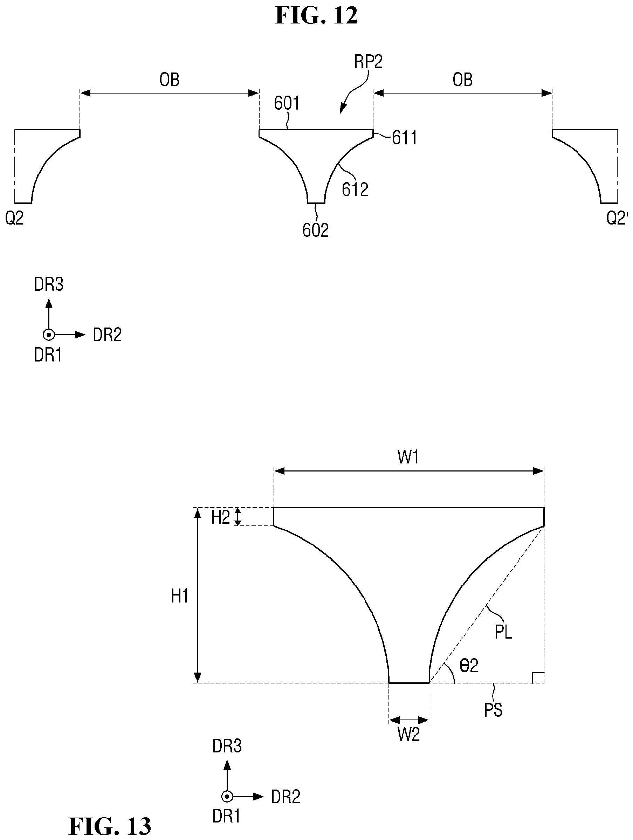

FIG. 8 is a plan view of portion of an embodiment of a first mask according to the disclosure. FIG. 9 is a plan view illustrating a deposition pattern portion of the first mask of FIG. 8. FIG. 10 is a cross-sectional view taken along line Q1-Q1' of FIG. 9. FIG. 11 is an enlarged cross-sectional view of portion of the first mask of FIG. 10. FIG. 12 is a cross-sectional view taken along line Q2-Q2' of FIG. 9. FIG. 13 is an enlarged cross-sectional view of portion of the first mask of FIG. 12.

Referring to FIGS. 8 and 9, a plurality of first openings OB may be defined in a first mask 520A including rib portions RP1 and RP2, which are disposed in a deposition pattern portion 544. The first mask 520A may be a mask for depositing light-emitting layers in the third emission areas EB of FIG. 3.

The first openings OB may be defined to correspond to the third emission areas EB of FIG. 3. The first openings OB may be spaced apart from one another. In an embodiment, the first openings OB may be spaced apart from one another in the first and second directions DR1 and DR2, for example. The distance, in the first direction DR1, between the first openings OB may be less than the distance, in the second direction DR2, between the first openings OB.

The first openings OB may have the same size or area. The first openings OB may have a quadrilateral shape in a plan view. The first openings OB may have a rectangular shape with a pair of long sides and a pair of short sides. In an embodiment, the long sides of each of the first openings OB may extend in the first direction DR1, and the short sides of each of the first openings OB may extend in the second direction DR2, for example. The long sides of each of the first openings OB may intersect the length direction of the first mask 520A (e.g., the second direction DR2). The short sides of each of the first openings OB may be parallel to the length direction of the first mask 520A.

The rib portions RP1 and RP2 may account for the entirety of the deposition pattern portion 544 except for the first openings OB. The rib portions RP1 and RP2 may include first rib portions RP1 and second rib portions RP2. The first rib portions RP1 may be parts of the deposition pattern portion 544 between the long sides of each of the first openings OB, and the second rib portions RP2 may be parts of the deposition pattern portion 544 between the short sides of each of the first openings OB. The first rib portions RP1 may extend in the first direction DR1 along the long sides of each of the first openings OB, and the second rib portions RP2 may extend in the second direction DR2 along the short sides of each of the first openings OB.

Referring to FIGS. 10 and 11, the first rib portions RP1 of the first mask 520A may include first surfaces 601 and second surfaces 602. The first surfaces 601 may be the surfaces of the first rib portions RP1 that are adjacent to a target substrate, and the second surfaces 602 may be the surfaces that are opposite to the first surfaces 601 and adjacent to a deposition source. The first surfaces 601 and the second surfaces 602 may be parallel to one another.

The first rib portions RP1 may further include first sides 611, which meet the first surfaces 601, and second sides 612, which meet the second surfaces 602. The first sides 611 and the second sides 612 may form the sidewalls of each of the first openings OB and the sidewalls of each of the first rib portions RP1. The first sides 611 may be adjacent to the first surfaces 601 and extended to (extend from) the first surfaces 601, and the second sides 612 may be adjacent to the second surfaces 602 and extended to (extend from) the second surfaces 602. The first sides 611 and the second sides 612 may be extended to one another. Thus, the second surfaces 602, the second sides 612, the first sides 611, and the first surfaces 601 may be sequentially arranged in the third direction DR3.

The first sides 611 may mainly extend in the third direction DR3. The second sides 612 may be curved. The first sides 611 may define a relatively small diameter of the first openings OB, and the second sides 612 may define a relatively large diameter of the first openings OB. That is, the diameter of the first openings OB, defined by the second sides 612, may be greater than the diameter of the first openings OB, defined by the first sides 611. The diameter of the first openings OB, defined by the second sides 612 may gradually decrease in the third direction DR3.

The first openings OB of the first mask 520A may be partially tapered. That is, the diameter of the first openings OB may gradually decrease in a direction from the second surfaces 602 to the first surfaces 601. The first openings OB may define a first taper angle $\theta1$. Here, the first taper angle $\theta1$ may refer to the side angle of the first rib portions RP1. In an embodiment, the first taper angle $\theta1$ may refer to the angle defined by a plane PS, extended from the second surfaces 602 of the first rib portions RP1, and the second sides 612 of the first rib portions RP1, for example. Specifically, the first taper angle $\theta1$ may be the angle defined by an imaginary line PL, connecting the points where the first and second sides 611 and 612 of each of the first rib portions RP1 meet and the points where the second side 612 and a second surface 602 of the corresponding first rib portion RP1 meet, and the plane PS, extended from the second surface 602 of the corresponding first rib portion RP1.

The first taper angle $\theta1$ may be calculated by the following equation:

$$Taper\ Angle = \frac{H1 - H2}{(W1 - W2)/2}$$

where H1 denotes the height of the first mask 520A (e.g., the length, in the third direction DR3, of the first mask 520A or the distance between the first surfaces 601 and the second surfaces 602), H2 denotes the height of the first sides 611 (or the length, in the third direction DR3, of the first sides 611), W1 denotes the width of the first surfaces 601, and W2 denotes the width of the second surfaces 602.

The first taper angle $\theta1$ may be about 54 degrees or less. Preferably, the first taper angle $\theta1$ may be about 47 degrees or less. When the first taper angle $\theta1$ is about 54 degrees or less, an irregular deposition of patterns that may be caused by a deposition shadow phenomenon may be prevented, and a deposition material may be prevented from being deposited over a larger area than desired.

Referring to FIGS. 12 and 13, the second rib portions RP2 of the first mask 520A may include first surfaces 601, second surfaces 602, first sides 611, and second sides 612. The first surfaces 601, the second surfaces 602, the first sides 611, and the second sides 612 of the second rib portions RP2 may be extensions of the first surfaces 601, the second surfaces 602, the first sides 611, and the second sides 612, respectively, of the first rib portions RP1, but may have a different width, height, and curvature from the first surfaces 601, the second surfaces 602, the first sides 611, and the second sides 612, respectively, of the first rib portions RP1.

The first sides 611 and the second sides 612 of the second rib portions RP2 may form some of the sidewalls of each of the first openings OB and some of the sidewalls of the second rib portions RP2.

The first openings OB may define a second taper angle $\Theta2$. Here, the second taper angle $\Theta2$ may refer to the side angle of the second rib portions RP2. In an embodiment, the second taper angle $\Theta2$ may refer to the angle defined by a plane PS, extended from the second surfaces 602 of the second rib portions RP2, and the second sides 612 of the second rib portions RP2, for example. Specifically, the second taper angle $\Theta2$ may be the angle defined by an imaginary line PL, connecting the points where the first and second sides 611 and 612 of each of the second rib portions RP2 meet and the points where the second side 612 and a second surface 602 of the corresponding second rib portion RP2 meet, and the plane PS, extended from the second surface 602 of the corresponding second rib portion RP2.

The second taper angle $\theta2$ may be calculated by the same equation as the first taper angle $\theta1$. The second taper angle $\theta2$ may be about 63 degrees or less. Preferably, the second taper angle $\theta2$ may be about 60 degrees or less. When the second taper angle $\theta2$ is about 63 degrees or less, an irregular deposition of patterns that may be caused by a deposition shadow phenomenon may be prevented, and the deposition material may be prevented from being deposited over a larger area than desired.

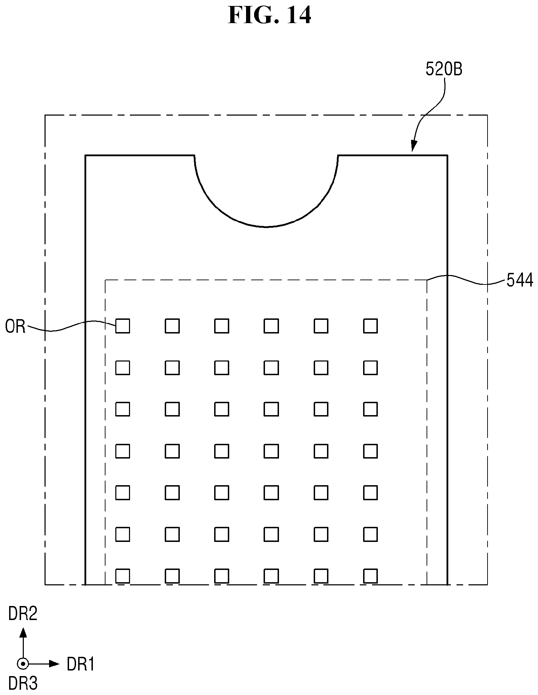

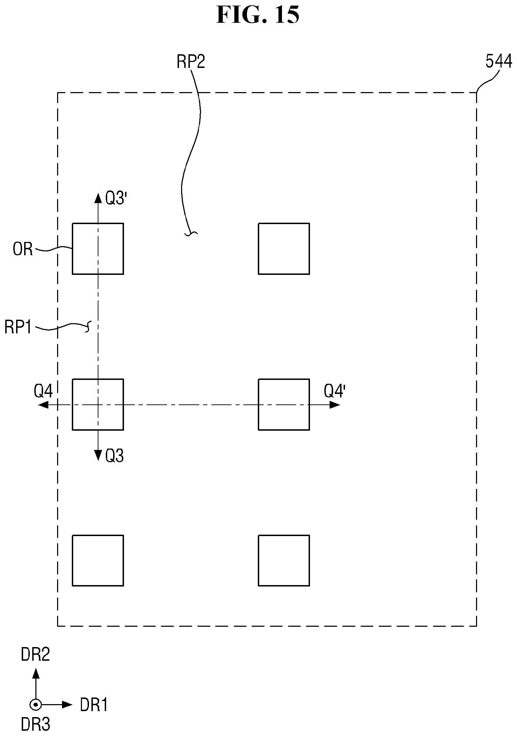

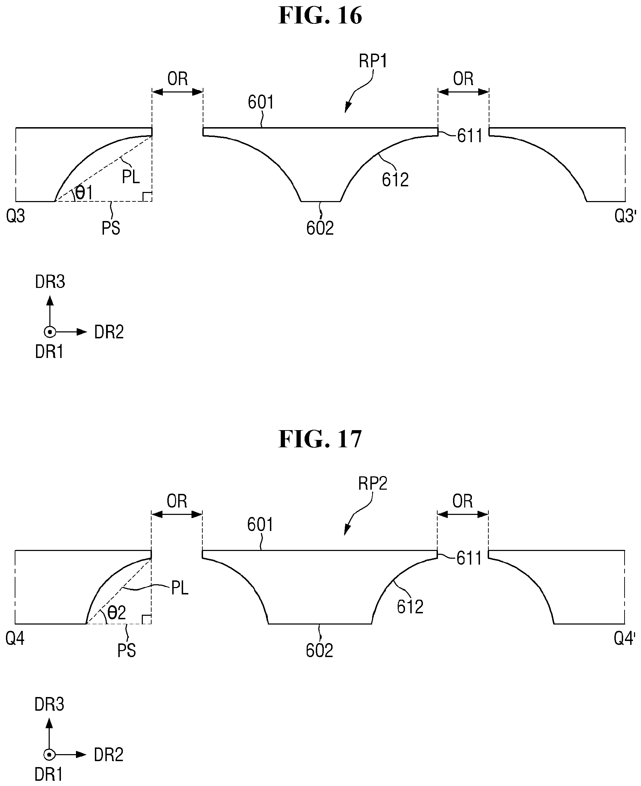

FIG. 14 is a plan view of portion of an embodiment of a second mask according to the disclosure. FIG. 15 is a plan view illustrating a deposition pattern portion of the second mask of FIG. 14. FIG. 16 is a cross-sectional view taken along line Q3-Q3' of FIG. 15. FIG. 17 is a cross-sectional view taken along line Q4-Q4' of FIG. 15.

Referring to FIGS. 14 through 17, a second mask 520B may include a plurality of second openings OR and rib portions RP1 and RP2, which are disposed in a deposition pattern portion 544. The second mask 520B may be a mask for depositing light-emitting layers in the first emission areas ER of FIG. 3.

The second openings OR may be defined to correspond to the first emission areas ER of FIG. 3. The second openings OR may be spaced apart from one another. In an embodiment, the second openings OR may be spaced apart from one another in the first and second directions DR1 and DR2, for example. The second openings OR may have the same size or area. The second openings OR may have a quadrilateral shape in a plan view. The second openings OR may have a rectangular shape with a pair of long sides and a pair of short sides. In an embodiment, the long sides of each of the second openings OR may extend in the second direction DR2, and the short sides of each of the second openings OR may extend in the first direction DR1, for example. The short sides of each of the second openings OR may intersect the length direction of the second mask 520B (e.g., the second direction DR2). The long sides of each of the second openings OR may be parallel to the length direction of the second mask 520B.

The rib portions RP1 and RP2 may include first rib portions RP1 and second rib portions RP2. The first rib portions RP1 may be parts of the deposition pattern portion 544 between the short sides of each of the second openings OR, and the second rib portions RP2 may be parts of the deposition pattern portion 544 between the long sides of each of the second openings OR. The first rib portions RP1 may extend in the first direction DR1 along the short sides of each of the second openings OR, and the second rib portions RP2 may extend in the second direction DR2 along the long sides of each of the second openings OR.

Referring to FIGS. 16 and 17, the first rib portions RP1 of the second mask 520B may include first surfaces 601 and second surfaces 602. The first surfaces 601 may be the surfaces of the first rib portions RP1 that are adjacent to a target substrate, and the second surfaces 602 may be the surfaces that are opposite to the first surfaces 601 and adjacent to a deposition source. The first surfaces 601 and the second surfaces 602 may be parallel to one another.

The first rib portions RP1 and the second rib portions RP2 of the second mask 520B may further include first sides 611, which meet the first surfaces 601, and second sides 612, which meet the second surfaces 602. The first sides 611 and the second sides 612 may form the sidewalls of each of the second openings OR, the sidewalls of each of the first rib portions RP1, and the sidewalls of each of the second rib portions RP2. The first sides 611 may be adjacent to the first surfaces 601 and extended to the first surfaces 601, and the second sides 612 may be adjacent to the second surfaces 602 and extended to the second surfaces 602. The first sides 611 and the second sides 612 may be extended to one another.

The first sides 611 may mainly extend in the third direction DR3. The second sides 612 may be curved. The first sides 611 may define a relatively small diameter of the second openings OR, and the second sides 612 may define a relatively large diameter of the second openings OR. That is, the diameter of the second openings OR, defined by the second sides 612, may be greater than the diameter of the second openings OR, defined by the first sides 611. The diameter of the second openings OR, defined by the second sides 612 may gradually decrease in the third direction DR3.

The second openings OR of the second mask 520B may be partially tapered. That is, the diameter of the second openings OR may gradually decrease in a direction from the second surfaces 602 to the first surfaces 601. The second openings OR may define first and second taper angles $\theta1$ and $\theta2$. Here, the first taper angle $\theta1$ may refer to the side angle of the first rib portions RP1, and the second taper angle $\theta2$ may refer to the side angle of the second rib portions RP2. In an embodiment, the first taper angle $\theta1$ may refer to the angle defined by a plane PS, extended from the second surfaces 602 of the first rib portions RP1, and the second sides 612 of the first rib portions RP1, and the second taper angle $\Theta2$ may refer to the angle defined by a plane PS, extended from the second surfaces 602 of the second rib portions RP2, and the second sides 612 of the second rib portions RP2, for example.

Specifically, the first taper angle $\theta1$ of the second openings OR may be the angle defined by an imaginary line PL, connecting the points where the first and second sides 611 and 612 of each of the first rib portions RP1 meet and the points where the second side 612 and a second surface 602 of the corresponding first rib portion RP1 meet, and the plane PS, extended from the second surface 602 of the corresponding first rib portion RP1, and the second taper angle $\Theta2$ of the second openings OR may be the angle defined by an imaginary line PL, connecting the points where first and second sides 611 and 612 of each of the second rib portions RP2 meet and the points where the second side 612 and a second surface 602 of the corresponding second rib portion RP2 meet, and the plane PS, extended from the second surface 602 of the corresponding second rib portion RP2.

The first taper angle $\theta1$ of the second openings OR may be about 54 degree or less, preferably, about 47 degrees or less. Also, the second taper angle $\theta2$ of the second openings OR may be about 63 degree or less, preferably, about 60 degrees or less. Accordingly, the second mask 520B may prevent an irregular deposition of patterns that may be caused by a deposition shadow phenomenon, and may also prevent the deposition material from being deposited over a larger area than desired.

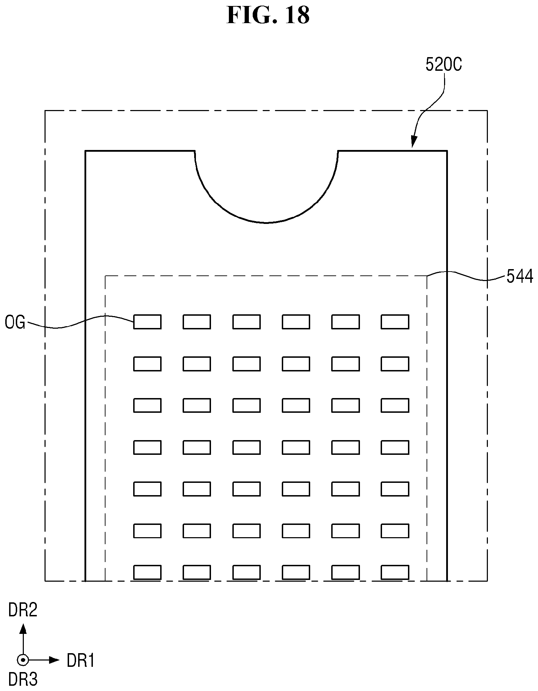

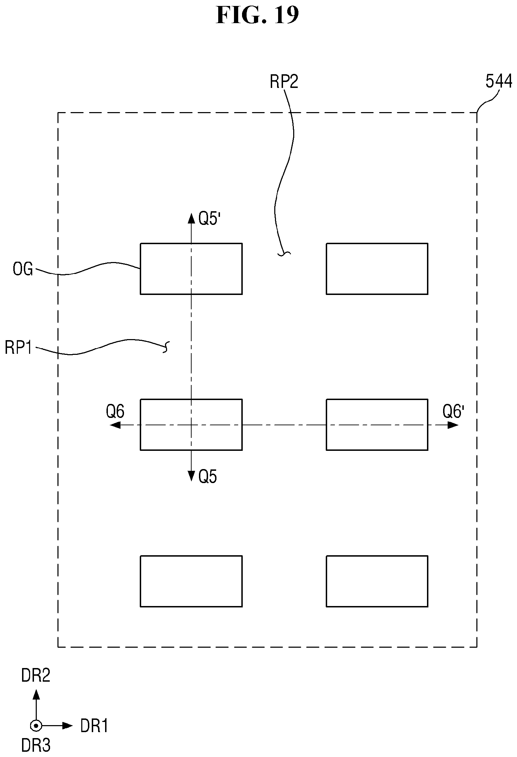

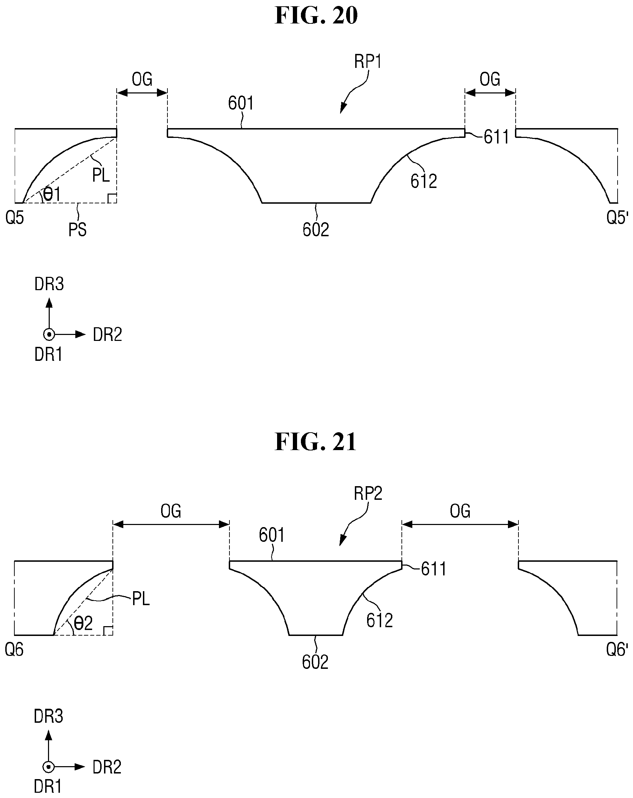

FIG. 18 is a plan view of portion of an embodiment of a third mask according to the disclosure. FIG. 19 is a plan view illustrating a deposition pattern portion of the third mask of FIG. 18. FIG. 20 is a cross-sectional view taken along line Q5-Q5' of FIG. 19. FIG. 21 is a cross-sectional view taken along line Q6-Q6' of FIG. 19.

Referring to FIGS. 18 through 21, a plurality of third openings OG and rib portions RP1 and RP2, which are defined in a deposition pattern portion 544, may be defined in a third mask 520C. The third mask 520C may be a mask for depositing light-emitting layers in the second emission areas EG of FIG. 3.

The third openings OG may be defined to correspond to the second emission areas EG of FIG. 3. The third openings OG may be spaced apart from one another. In an embodiment, the third openings OG may be spaced apart from one another in the first and second directions DR1 and DR2, for example. The third openings OG may have the same size or area. The third openings OG may have a quadrilateral shape in a plan view. The third openings OG may have a rectangular shape with a pair of long sides and a pair of short sides. In an embodiment, the long sides of each of the third openings OG may extend in the first direction DR1, and the short sides of each of the third openings OG may extend in the second direction DR2, for example. The long sides of each of the third openings OG may intersect the length direction of the third mask 520C (e.g., the second direction DR2). The short sides of each of the third openings OG may be parallel to the length direction of the third mask 520C.

The rib portions RP1 and RP2 may include first rib portions RP1 and second rib portions RP2. The first rib portions RP1 may be parts of the deposition pattern portion 544 between the long sides of each of the third openings OG, and the second rib portions RP2 may be parts of the deposition pattern portion 544 between the short sides of each of the third openings OG. The first rib portions RP1 may extend in the first direction DR1 along the long sides of each of the third openings OG, and the second rib portions RP2 may extend in the second direction DR2 along the short sides of each of the third openings OG.

Referring to FIGS. 19 and 21, the first rib portions RP1 of the third mask 520C may include first surfaces 601 and second surfaces 602. The first surfaces 601 may be the surfaces of the first rib portions RP1 that are adjacent to a target substrate, and the second surfaces 602 may be the surfaces that are opposite to the first surfaces 601 and adjacent to a deposition source. The first surfaces 601 and the second surfaces 602 may be parallel to one another.

The first rib portions RP1 and the second rib portions RP2 of the third mask 520C may further include first sides 611, which meet the first surfaces 601, and second sides 612, which meet the second surfaces 602. The first sides 611 and the second sides 612 may form the sidewalls of each of the third openings OG, the sidewalls of each of the first rib portions RP1, and the sidewalls of each of the second rib portions RP2. The first sides 611 may be adjacent to the first surfaces 601 and extended to the first surfaces 601, and the second sides 612 may be adjacent to the second surfaces 602 and extended to the second surfaces 602. The first sides 611 and the second sides 612 may be extended to one another.

The first sides 611 may mainly extend in the third direction DR3. The second sides 612 may be curved. The first sides 611 may define a relatively small diameter of the third openings OG, and the second sides 612 may define a relatively large diameter of the third openings OG. That is, the diameter of the third openings OG, defined by the second sides 612, may be greater than the diameter of the third openings OG, defined by the first sides 611. The diameter of the third openings OG, defined by the second sides 612 may gradually decrease in the third direction DR3.

The third openings OG of the third mask 520C may be partially tapered. That is, the diameter of the third openings OG may gradually decrease in a direction from the second surfaces 602 to the first surfaces 601. The third openings OG may define first and second taper angles $\theta1$ and $\theta2$. Here, the first taper angle $\theta1$ may refer to the side angle of the first rib portions RP1, and the second taper angle $\theta2$ may refer to the side angle of the second rib portions RP2. In an embodiment, the first taper angle $\theta1$ may refer to the angle defined by a plane PS, extended from the second surfaces 602 of the first rib portions RP1, and the second sides 612 of the first rib portions RP1, and the second taper angle $\theta2$ may refer to the angle defined by a plane PS, extended from the second surfaces 602 of the second rib portions RP2, and the second sides 612 of the second rib portions RP2, for example.

Specifically, the first taper angle $\theta1$ of the third openings OG may be the angle defined by an imaginary line PL, connecting the points where first and second sides 611 and 612 of each of the first rib portions RP1 meet and the points where the second side 612 and a second surface 602 of the corresponding first rib portion RP1 meet, and the plane PS, extended from the second surface 602 of the corresponding first rib portion RP1, and the second taper angle $\Theta2$ of the third openings OG may be the angle defined by an imaginary line PL, connecting the points where first and second sides 611 and 612 of each of the second rib portions RP2 meet and the points where the second side 612 and a second surface 602 of the corresponding second rib portion RP2 meet, and the plane PS, extended from the second surface 602 of the corresponding second rib portion RP2.

The first taper angle $\theta1$ of the third openings OG may be about 54 degree or less, preferably, about 47 degrees or less. Also, the second taper angle $\Theta2$ of the third openings OG may be about 63 degree or less, preferably, about 60 degrees or less. Accordingly, the third mask 520C may prevent an irregular deposition of patterns that may be caused by a deposition shadow phenomenon, and may also prevent the deposition material from being deposited over a larger area than desired.

As already mentioned above, the first taper angle θ1 of the sides of the first rib portions RP1 of each of the first, second, and third masks 520A, 520B, and 520C that intersect the length direction of the first, second, and third masks 520A, 520B, and 520C may be about 54 degrees or less, and the second taper angle Θ2 of the sides of the second rib portions RP2 of each of the first, second, and third masks 520A, 520B, and 520C that are parallel to the length direction of the first, second, and third masks 520A, 520B, and 520C may be about 63 degrees or less. Accordingly, during deposition processes using the first, second, and third masks 520A, 520B, and 520C, an irregular deposition of patterns that may be caused by a deposition shadow phenomenon may be prevented, and deposition materials may be prevented from being deposited over larger areas than desired.

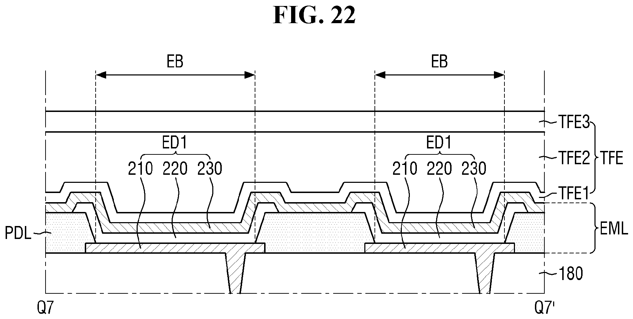

FIG. 22 is a cross-sectional view, taken along line Q7-Q7' of FIG. 3, of another embodiment of a display panel according to the disclosure. The embodiment of FIG. 22 will hereinafter be described, focusing mainly on the differences with the embodiment of FIGS. 3 and 4.

Referring to FIG. 22, third emission areas EB may be disposed adjacent to each other. A light-emitting layer 220 may be disposed continuously in the third emission areas EB.

Specifically, first light-emitting elements ED1 may be disposed in their respective third emission areas EB. The first light-emitting elements ED1 may include first electrodes 210, the light-emitting layer 220, and a second electrode 230. The first electrodes 210 may be disposed in their respective third emission areas EB as patterns.

The light-emitting layer 220 may be disposed continuously in the respective third emission areas EB. The light-emitting layer 220 may cover the first electrodes 210 and a bank PDL and may be disposed continuously in the third emission areas EB, beyond portion of the bank PDL between the third emission areas EB.

The light-emitting layer 220 may be formed by a mask in which an opening that corresponds to at least two third emission areas EB is defined. In an embodiment, the opening of the mask may be large enough to cover at least two third emission areas EB, for example. As a result, one light-emitting layer 220 may be formed continuously in two or more third emission areas EB.

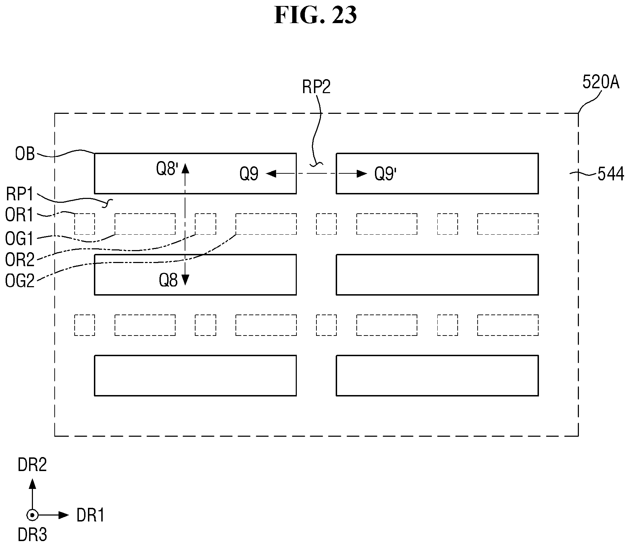

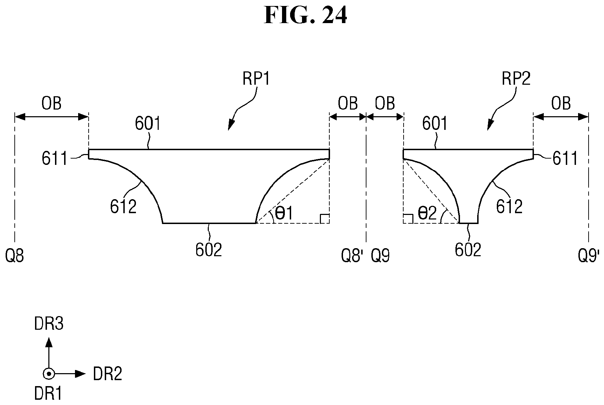

The mask for forming the light-emitting layer 220 of FIG. 22 will hereinafter be described with reference to FIGS. 23 and 24.

FIG. 23 is a plan view of another embodiment of a first mask according to the disclosure. FIG. 24 is a cross-sectional view taken along lines Q8-Q8' and Q9-Q9' of FIG. 23.

For convenience, not only first openings OB of a first mask 520A but also second openings OR1 and OR2 of a second mask and third openings OG1 and OG2 of a third mask are illustrated in FIG. 23 to show the differences in structure between the first openings OB of the first mask 520A, the second openings OR1 and OR2, and the third openings OG1 and OG2. Obviously, the second openings OR1 and OR2 and the third openings OG1 and OG2 are not actually defined in the first mask 520A. The embodiment of FIGS. 23 and 24 will hereinafter be described, focusing mainly on the differences with the previous embodiments.

Referring to FIGS. 23 and 24, a plurality of first openings OB may be defined in the first mask 520A including rib portions RP1 and RP2, which are disposed in a deposition pattern portion 544. The first mask 520A may be a mask for depositing the light-emitting layer 220 of FIG. 22, which extends into multiple third emission areas EB.

The first openings OB of the first mask 520A may have a similar shape and layout to their counterpart of FIGS. 8 and 9. In an embodiment, the first openings OB may be spaced apart from one another in the first and second directions DR1 and DR2, for example. The first openings OB may have the same size or area. The first openings OB may have a quadrangular shape, e.g., rectangular shape with a pair of long sides and a pair of short sides. The long sides of each of the first openings OB may intersect the length direction of the first mask 520A (e.g., the second direction DR2). The short sides of each of the first openings OB may be parallel to the length direction of the first mask 520A.

The length of the long sides of each of the first openings OB may be greater than the length of the long sides of each of the first openings OB of FIGS. 8 and 9. Each of the first openings OB may correspond to two third emission areas EB, whereas each of the first openings OB of FIGS. 8 and 9 corresponds to one third emission area EB. In an embodiment, referring to FIG. 23, each of the first openings OB may overlap with two first openings (OR1 and OR2) and two second openings (OG1 and OG2) in the second direction DR2, in a plan view, for example. As a result, a deposition material passing through the first openings OB during a deposition process may be continuously formed a light-emitting layer 220 in two third emission areas EB at the same time.

Referring to FIG. 24, the first openings OB, like their counterpart of FIGS. 8 through 13, may be partially tapered. The first openings OB may form first and second taper angles θ1 and Θ2. The first taper angle θ1 of the first openings OB may be about 54 degrees or less, preferably about 47 degrees or less. The second taper angle Θ2 of the first openings OB may be about 63 degrees or less, preferably about 60 degrees or less. Accordingly, the first mask 520A may prevent an irregular deposition of patterns that may be caused by a deposition shadow phenomenon, and may also prevent the deposition material from being deposited over a larger area than desired.

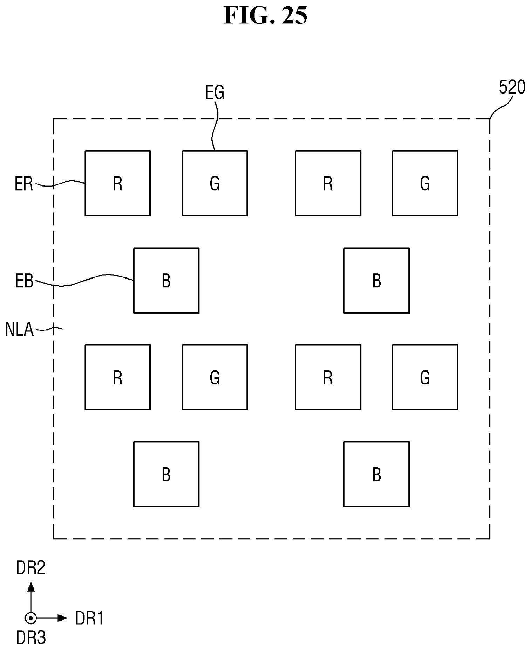

FIG. 25 is an enlarged plan view of another embodiment of portion of a display panel according to the disclosure.

Referring to FIG. 25, a display panel 300 may include a plurality of emission areas ER, EG, and EB and a non-emission area NLA. The emission areas ER, EG, and EB may include first emission areas ER, second emission areas EG, and third emission areas EB. In a first row, the first emission areas ER and the second emission areas EG may be alternately arranged in the first direction DR1. In a second row, the third emission areas EB may be spaced apart from one another in the first direction DR1. First, second, and third emission areas ER, EG, and EB that are disposed adjacent to one another may function as a pixel.

The emission areas ER, EG, and EB may have substantially the same layout as their counterpart of FIG. 3, but may have a different shape from their counterpart of FIG. 3 in a plan view, e.g., a square shape, but the disclosure is not limited thereto. That is, the emission areas ER, EG, and EB may have various other shapes, such as a circular or another polygonal shape, as long as they have the same shape and size.

The emission areas ER, EG, and EB may be formed by masks in which openings that correspond to the emission areas ER, EG, and EB are defined. In an embodiment, the emission areas ER, EG, and EB may be formed by a mask in which openings that correspond to the first emission areas ER are defined, a mask in which openings that correspond to the second emission areas EG are defined, and a mask including openings that correspond to the third emission areas EB, for example.

The masks for forming the emission areas ER, EG, and EB of FIG. 25 will hereinafter be described.

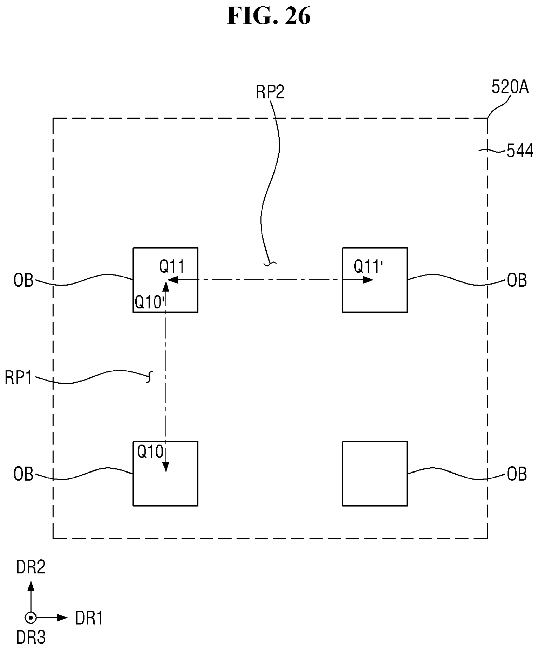

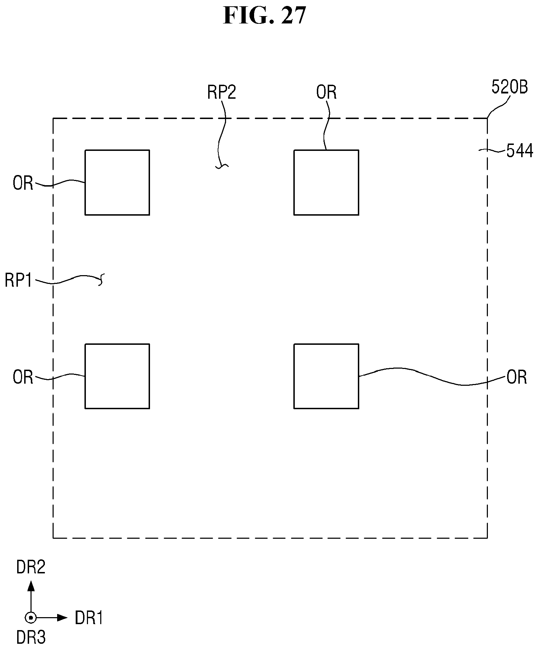

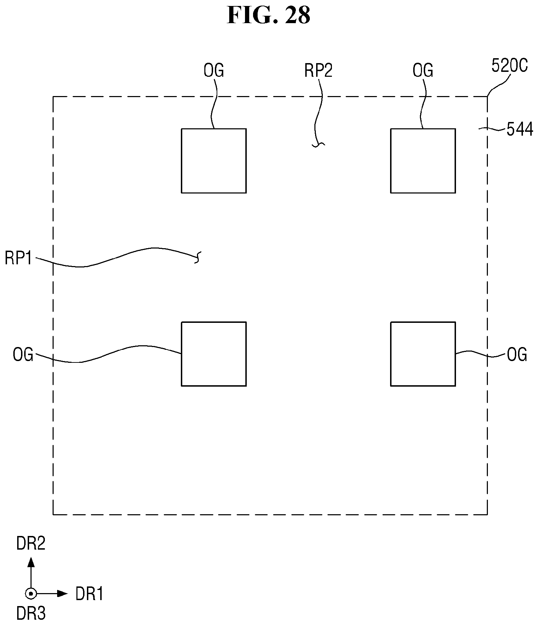

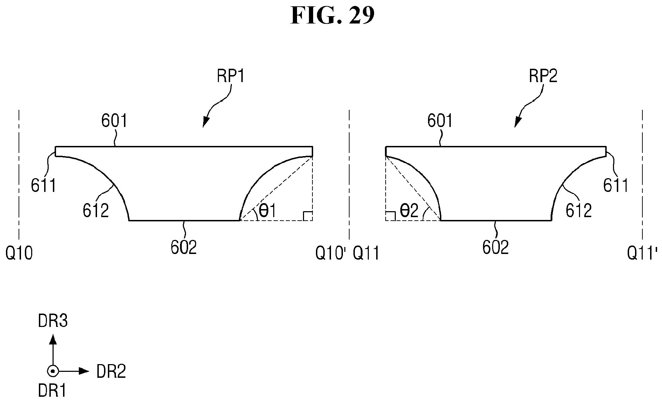

FIG. 26 is a plan view of another embodiment of a first mask according to the disclosure. FIG. 27 is a plan view of another embodiment of a second mask according to the disclosure. FIG. 28 is a plan view of another embodiment of a third mask according to the disclosure. FIG. 29 is a cross-sectional view taken along lines Q10-Q10' and Q11-Q11' of FIG. 26.

Referring to FIGS. 26 through 29, a first mask 520A may include a plurality of first openings OB, which are defined in a deposition pattern portion 544 of the first mask 520A, a second mask 520B may include a plurality of second openings OR, which are disposed in a deposition pattern portion 544 of the second mask 520B, and a third mask 520C may include a plurality of third openings OG, which are disposed in a deposition pattern portion 544 of the third mask 520C. The first openings OB may correspond to the third emission areas EB of FIG. 25, the second openings OR may correspond to the first emission areas ER of FIG. 25, and the third openings OG may correspond to the second emission areas EG of FIG. 25.

Each of the first, second, and third masks 520A, 520B, and 520C may further include rib portions RP1 and RP2, which are disposed between the first openings OB, between the second openings OR, or between the third openings OG. The rib portions RP1 and RP2 may include first rib portions RP1, which are parts of the deposition pattern portion 544 between the first openings OB, between the second openings OR, or between the third openings OG that are apart from one another in the second direction DR2, and second rib portions RP2, which are parts of the deposition pattern portion 544 between the first openings OB, between the second openings OR, or between the third openings OG that are apart from one another in the first direction DR1. Specifically, in the case of, e.g., the first mask 520A, parts of the deposition pattern portion 544 that are apart from one another in the length direction of the first mask 520A, i.e., in the second direction DR2, may be the first rib portions RP1, and parts of the deposition pattern portion 544 that are apart from one another in the first direction DR1, which intersects the length direction of the first mask 520A, may be the second rib portions RP2.

The first openings OB of the first mask 520A, the second openings OR of the second mask 520B, and the third openings OG of the third mask 520C may define first and second taper angles $\theta 1$ and $\theta 2$.

Referring to FIG. 29, the first rib portions RP1 and the second rib portions RP2 of the first mask 520A may include first surfaces 601 and second surfaces 602 and may further include first sides 611, which meet the first surfaces 601, and second sides 612, which meet the second surfaces 602.

The first openings OB of the first mask 520A may be partially tapered. That is, the diameter of the first openings OB may gradually decrease in a direction from the second surfaces 602 to the first surfaces 601. The first openings OB may define first and second taper angles $\theta 1$ and $\Theta 2$. The first taper angle $\theta 1$ may be about 54 degrees or less, preferably, about 47 degrees or less. The second taper angle $\Theta 2$ may be about 63 degrees or less, preferably, about 60 degrees or less. Accordingly, the first mask 520A may prevent an irregular deposition of patterns that may be caused by a deposition shadow phenomenon, and may also prevent the deposition material from being deposited over a larger area than desired.

FIG. 29 illustrates a cross-sectional view of the first mask 520A, but the above description of the first mask 520A may also be applicable to the second and third masks 520B and 520C.

A method of fabricating a display device using first masks 520A, second masks 520B, and third masks 520C will hereinafter be described. Specifically, it will hereinafter be described how to form light-emitting layers 220 in the emission areas ER, EG, and EB of FIG. 3 with the use of first masks 520A, second masks 520B, and third masks 520C.

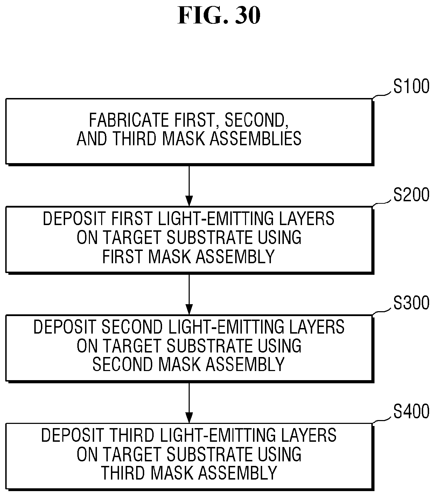

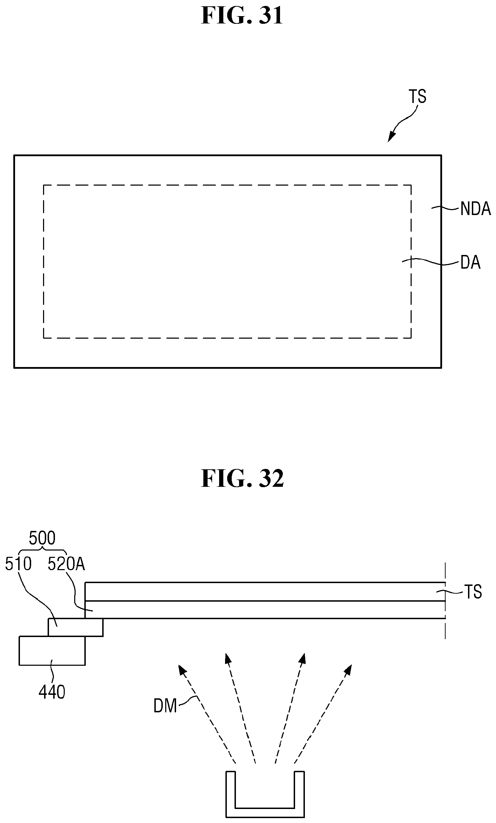

FIG. 30 is a flowchart illustrating an embodiment of a method of fabricating a display device according to the disclosure. FIGS. 31 through 35 illustrate steps of the method of FIG. 30.

Referring to FIG. 30, the method of fabricating a display device may include fabricating first, second, and third mask assemblies (S100), depositing first light-emitting layers on a target substrate using the first mask assembly (S200), depositing second light-emitting layers on the target substrate using the second mask assembly (S300), and depositing third light-emitting layers on the target substrate using the third mask assembly (S400). Herein, the first light-emitting layers may corresponds to the third emission area, the second light-emitting layers may correspond to the first emission area, and the third light emitting layers may correspond to the second emission area

First, the first, second, and third mask assemblies are fabricated (S100). The first mask assembly may be obtained by mounting first masks 520A in the embodiment of FIGS. 8 through 13 in the mask assembly 500 of FIG. 6. The second mask assembly may be obtained by mounting second masks 520B in the embodiment of FIGS. 14 through 17 in the mask assembly 500 of FIG. 6. The third mask assembly may be obtained by mounting third masks 520C in the embodiment of FIGS. 18 through 21 in the mask assembly 500 of FIG. 6. The first masks 520A, the second masks 520B, and the third masks 520C have already been described above with reference to FIGS. 8 through 13, 14 through 17, and 18 through 21, respectively, and thus, detailed descriptions thereof will be omitted.

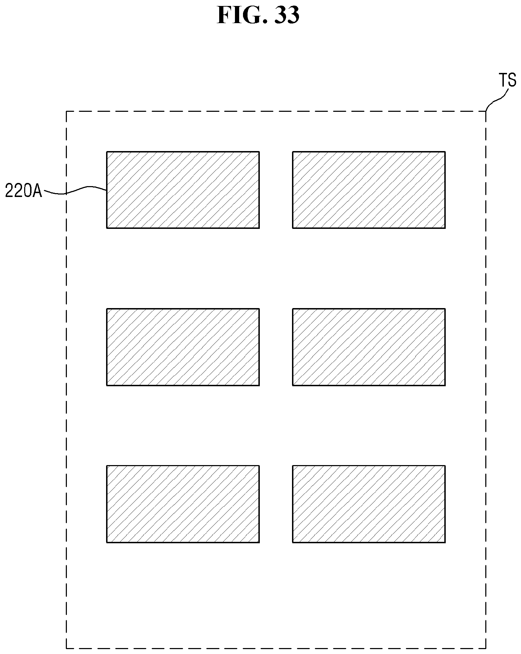

Thereafter, referring to FIGS. 31 and 33, first light-emitting layers 220A are deposited on the target substrate TS using a first mask assembly 500.

Specifically, the target substrate TS is prepared. The target substrate TS may be a substrate with the bank PDL of FIG. 4 formed thereon. The target substrate TS may include a display area DA and a non-display area NDA defined thereon.

Thereafter, referring to FIGS. 5 and 32, the first mask assembly 500 is fixed on the stage 440 in the deposition equipment 400. Thereafter, the target substrate TS is placed on the first mask assembly 500. The first masks 520A may be aligned and in contact with one another in the first mask assembly 500.

Thereafter, a deposition material DM for forming the first light-emitting layers 220A is deposited from a deposition source 430 onto the target substrate TS. The deposition material DM for forming the first light-emitting layers 220A may be deposited onto the target substrate TS through first openings OB of each of the first masks 520A. The first light-emitting layers 220A are formed by depositing the deposition material DM for forming the first light-emitting layers 220A to correspond to the first openings OB. The first light-emitting layers 220A may correspond to the third emission areas EB of FIG. 3.

Sides of each of the first openings OB that intersect the length direction of the first masks 520A may have a first taper angle of about 54 degrees or less, and sides of each of the first openings OB that are parallel to the length direction of the first masks 520A may have a second taper angle of about 63 degrees or less. Accordingly, the deposition shadow phenomenon of the deposition material DM may be reduced, and the first light-emitting layers 220A may be uniformly deposited over a desired area.

Thereafter, second light-emitting layers 220B are deposited on the target substrate TS using the second mask assembly (S300).

Specifically, after the formation of the first light-emitting layers 220A, the first mask assembly 500 is replaced with the second mask assembly, and the second mask assembly is aligned with the target substrate TS. Thereafter, the second light-emitting layers 220B are formed by depositing a deposition material DM for forming the second light-emitting layers 220B from another deposition source 430 on the target substrate TS.

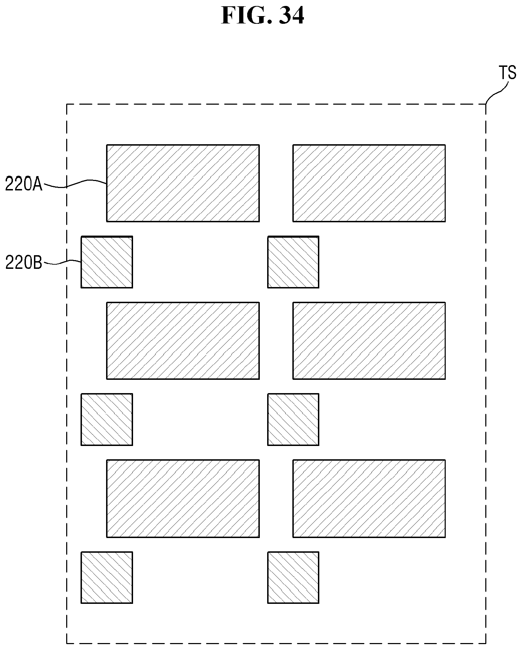

Referring to FIG. 34, the deposition material DM for forming the second light-emitting layers 220B may be deposited on the target substrate TS through second openings OR of each of the second masks 520B. The second light-emitting layers 220B are formed by depositing the deposition material DM for forming the second light-emitting layers 220B to correspond to the second openings OR. The second light-emitting layers 220B may correspond to the first emission areas ER of FIG. 3.

Sides of each of the second openings OR that intersect the length direction of the second masks 520B may have a first taper angle of about 54 degrees or less, and sides of each of the second openings OR that are parallel to the length direction of the second masks 520B may have a second taper angle of about 63 degrees or less. Accordingly, the deposition shadow phenomenon of the deposition material DM for forming the second light-emitting layers 220B may be reduced, and the second light-emitting layers 220B may be uniformly deposited over a desired area.

Thereafter, third light-emitting layers 220C are deposited on the target substrate TS using the third mask assembly (S400).

Specifically, after the formation of the second light-emitting layers 220B, the second mask assembly is replaced with the third mask assembly, and the third mask assembly is aligned with the target substrate TS. Thereafter, the third light-emitting layers 220C are formed by depositing a deposition material DM for forming the third light-emitting layers 220C from another deposition source 430 on the target substrate TS.

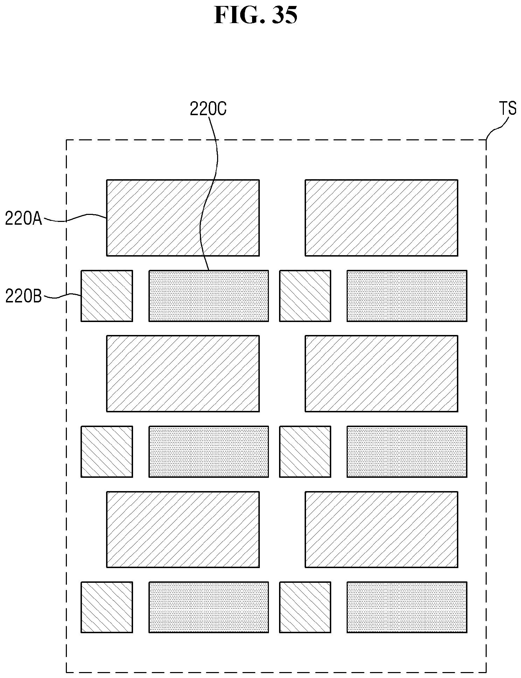

Referring to FIG. 35, the deposition material DM for forming the third light-emitting layers 220C may be deposited on the target substrate TS through third openings OG of each of the third masks 520C. The third light-emitting layers 220C are formed by depositing the deposition material DM for forming the third light-emitting layers 220C to correspond to the second openings OG. The third light-emitting layers 220C may correspond to the second emission areas EG of FIG. 3.

Sides of each of the third openings OG that intersect the length direction of the third masks 520C may have a first taper angle of about 54 degrees or less, and sides of each of the third openings OG that are parallel to the length direction of the third masks 520C may have a second taper angle of about 63 degrees or less. Accordingly, the deposition shadow phenomenon of the deposition material DM for forming the third light-emitting layers 220C may be reduced, and the third light-emitting layers 220C may be uniformly deposited over a desired area.

In this manner, the first light-emitting layers 220, the second light-emitting layers 220B, and the third light-emitting layers 220C may be formed in the first emission areas ER, the second emission areas EG, and the third emission areas EB, respectively.

Table 1 below shows deposition shadow length measurements for different first taper angles and for different incidence angles of a deposition material.

[Table 1]

| First Taper Angle (°) | Mask Thickness (μm) | Angle of Incidence of Deposition Material (°) | Length of Deposition Shadow (μm) |
|---|---|---|---|
| 54 | 20 | 50.2 | 8.186382 |
| 49 | 20 | 47 | 8.208622 |

Referring to Table 1, when the incidence angle of the deposition material is about 50.2 degrees and the first taper angle of a mask is about 54 degrees, the length of the deposition shadow is about 8.18 micrometers (μm), and when the incidence angle of the deposition material is about 47 degrees and the first taper angle of the mask is about 49 degrees, the length of the deposition shadow is about 8.20 μm.

This shows that a first taper angle of about 54 degrees or less may result in a deposition shadow length less than a predetermined allowable level.

As described above, by controlling the taper angle of openings of a mask, an irregular deposition of patterns that may be caused by a deposition shadow phenomenon may be prevented, and the deposition material may also be prevented from being deposited over a larger area than desired.

In concluding the detailed description, those skilled in the art will appreciate that many variations and modifications may be made to the preferred embodiments without substantially departing from the principles of the disclosure. Therefore, the disclosed preferred embodiments of the disclosure are used in a generic and descriptive sense only and not for purposes of limitation. The disclosure of the invention also includes the following numbered clauses:

Clause 1. A mask comprising: a plurality of deposition pattern portions; and rib portions disposed between the plurality of deposition pattern portions, wherein a plurality of openings is defined in each of the plurality of deposition pattern portions, the mask has a width in a first direction and a length in a second direction which intersects the first direction, sides of each of openings which are parallel to the first direction, among the plurality of openings, have a first taper angle, and the first taper angle is about 54 degrees or less.

Clause 2. The mask of clause 1, wherein the first taper angle is about 47 degrees or less.

Clause 3. The mask of clause 1 or 2, wherein the mask has a first surface, a second surface, which is opposite to the first surface, a first side, which is extended to the first surface, and a second side, which is extended to the second surface, and the first and second sides are extended to each other.

Clause 4. The mask of clause 3, wherein a diameter of the plurality of openings gradually decreases in a direction from the second surface to the first surface.

Clause 5. The mask of clause 3 or 4, wherein sides of each of openings which are parallel to the second direction, among the plurality of openings, have a second taper angle, and the second taper angle is about 63 degrees or less.

Clause 6. The mask of clause 5, wherein the second taper angle is about 60 degrees or less.

Clause 7. The mask of clause 5 or 6, wherein the first and second taper angles are angles defined by an imaginary line, connecting points where the first and second sides meet and points where the second surface and the second side meet, and a plane, extended from the second surface.

Clause 8. A mask comprising: a plurality of rib portions disposed between a plurality of openings, wherein the mask has a width in a first direction and a length in a second direction which intersects the first direction, the plurality of rib portions includes first rib portions, which are disposed between openings spaced apart from one another in the second direction among the plurality of openings, and second rib portions, which are disposed between openings to be spaced apart from one another in the first direction among the plurality of openings, sides of each of the first rib portions have a first taper angle, and the first taper angle is about 54 degrees or less.

Clause 9. The mask of clause 8, wherein the first taper angle is about 47 degrees or less.

Clause 10. The mask of clause 8, wherein sides of each of the second rib portions have a second taper angle, and the second taper angle is about 63 degrees or less.

Clause 11. The mask of clause 10, wherein the second taper angle is about 60 degrees or less.

Clause 12. The mask of clause 10, wherein each of the first rib portions and the second rib portions includes a first surface, a second surface, which is opposite to the first surface, a first side, which is extended to the first surface, and a second side, which is extended to the second surface, and the first and second sides are extended to each other.

Clause 13. The mask of clause 12, wherein the first and second taper angles are angles defined by an imaginary line, connecting points where the first and second sides meet and points where the second surface and the second side meet, and a plane, extended from the second surface.

Clause 14. A mask assembly comprising: a frame in which a frame opening is defined; and a plurality of masks disposed on the frame, covering the frame opening and having a width in a first direction and a length in a second direction which intersects the first direction, each of the plurality of masks including: a plurality of rib portions disposed between a plurality of openings, the plurality of rib portions including: first rib portions, which are disposed between openings spaced apart from one another in the second direction among the plurality of openings; and second rib portions, which are disposed between the openings to be spaced apart from one another in the first direction among the plurality of openings, wherein sides of each of the first rib portions have a first taper angle, and the first taper angle is about 54 degrees or less.

Clause 15. The mask assembly of clause 14, wherein each of the plurality of masks further includes fixing portions, which overlap with the frame and are fixed to the frame, and the fixing portions are disposed at opposite ends, in a length direction, of a corresponding mask.

Clause 16. The mask assembly of clause 14, wherein the first taper angle is about 47 degrees or less.

Clause 17. The mask assembly of clause 14, wherein sides of each of the second rib portions have a second taper angle, and the second taper angle is about 63 degrees or less.

Clause 18. The mask assembly of clause 17, wherein the second taper angle is about 60 degrees or less.

Clause 19. The mask assembly of clause 17, wherein each of the first rib portions and the second rib portions includes a first surface, a second surface, which is opposite to the first surface, a first side, which is extended to the first surface, and a second side, which is extended to the second surface, and the first and second sides are extended to each other.

Clause 20. The mask assembly of clause 19, wherein the first and second taper angles are angles defined by an imaginary line, connecting points where the first and second sides meet and points where the second surface and the second side meet, and a plane, extended from the second surface.

Clause 21. A method of fabricating a display device, the method comprising: fabricating first, second, and third mask assemblies, each of the first, second, and third mask assemblies including masks; forming first light-emitting layers on a target substrate using the first mask assembly; forming second light-emitting layers on the target substrate using the second mask assembly; and forming third light-emitting layers on the target substrate using the third mask assembly, wherein each of the masks includes a plurality of rib portions disposed between a plurality of openings, each of the masks has a width in a first direction and a length in a second direction which intersects the first direction, the plurality of rib portions includes: first rib portions, which are disposed between openings spaced apart from one another in the second direction among the plurality of openings; and second rib portions, which are disposed between openings to be spaced apart from one another in the first direction among the plurality of openings, sides of each of the first rib portions have a first taper angle, and the first taper angle is about 54 degrees or less.

Clause 22. The method of clause 21, wherein the target substrate includes first emission areas, in which the first light-emitting layers are formed, second emission areas, in which the second light-emitting layers are formed, and third emission areas, in which the third light-emitting layers are formed, the first light-emitting layers emit blue light, the second light-emitting layers emit red light, and the third light-emitting layers emit green light.

Clause 23. The method of clause 22, wherein the first emission areas are repeatedly arranged and spaced apart from one another in the first direction, and the second emission areas and the third emission areas are disposed in the second direction with respect to the first emission areas and are alternately arranged in the first direction.

Clause 24. The method of clause 23, wherein the second emission areas and the third emission areas overlap with the first emission areas in the second direction, in a plan view.

Clause 25. The method of clause 23, wherein at least two of the second emission areas and at least two of the third emission areas overlap with one of the first emission areas in the second direction, in a plan view.

Clause 26. The method of clause 21, wherein the first taper angle is about 47 degrees or less.

Clause 27. The method of clause 21, wherein sides of each of the second rib portions have a second taper angle, and the second taper angle is about 63 degrees or less.

Clause 28. The method of clause 27, wherein the second taper angle is about 60 degrees or less.

Clause 29. The method of clause 27, wherein each of the first rib portions and the second rib portions includes a first surface, a second surface, which is opposite to the first surface, a first side, which is extended to the first surface, and a second side, which is extended to the second surface, and the first and second sides are extended to each other.

Clause 30. The method of clause 29, wherein the first and second taper angles are angles defined by an imaginary line, connecting points where the first and second sides meet and points where the second surface and the second side meet, and a plane, extended from the second surface.

**Claims**

1. A mask comprising:

   a plurality of rib portions disposed between a plurality of openings,
   wherein the mask has a width in a first direction and a length in a second direction which intersects the first direction,
   the plurality of rib portions includes first rib portions, which are disposed between openings spaced apart from one another in the second direction among the plurality of openings, and second rib portions, which are disposed between openings to be spaced apart from one another in the first direction among the plurality of openings,
   sides of each of the first rib portions have a first taper angle, and
   the first taper angle is about 54 degrees or less.

2. The mask of claim 1, wherein the first taper angle is about 47 degrees or less.

3. The mask of claim 1 or 2, wherein sides of each of the second rib portions have a second taper angle, and the second taper angle is about 63 degrees or less, optionally wherein the second taper angle is about 60 degrees or less.

4. The mask of any one of claims 1 to 4, wherein each of the first rib portions and the second rib portions includes a first surface, a second surface, which is opposite to the first surface, a first side, which is extended to the first surface, and a second side, which is extended to the second surface, and
   the first and second sides are extended to each other.

5. The mask of claim 4, wherein the first and second taper angles are angles defined by an imaginary line, connecting points where the first and second sides meet and points where the second surface and the second side meet, and a plane, extended from the second surface.

6. The mask of claim 4 or 5, wherein a diameter of the plurality of openings gradually decreases in a direction from the second surface to the first surface.

7. The mask of any one of claims 1 to 6, wherein the mask further includes fixing portions, for fixing to a frame of a frame assembly, wherein the fixing portions are disposed at opposite end portions of the mask.

8. A mask as claimed in any one of claims 1 to 7, wherein the mask includes a plurality of deposition pattern portions, and a rib portion between adjacent deposition pattern portions.

9. A mask assembly comprising:

   a frame in which a frame opening is defined; and
   a plurality of masks configured to be disposed on the frame to cover the frame opening, wherein the masks are in accordance with any one of claims 1 to 8.

10. The mask assembly of claim 9, wherein each of the plurality of masks further includes fixing portions, which overlap with the frame and are fixed to the frame, and
    the fixing portions are disposed at opposite ends, in a length direction, of a corresponding mask.

11. A method of fabricating a display device, the method comprising:

    fabricating first, second, and third mask assemblies, each of the first, second, and third mask assemblies including masks;
    forming first light-emitting layers on a target substrate using the first mask assembly;
    forming second light-emitting layers on the target substrate using the second mask assembly; and
    forming third light-emitting layers on the target substrate using the third mask assembly,
    wherein
    each of the masks is a mask in accordance with any one of claims 1 to 8.

12. The method of claim 11, wherein the target substrate includes first emission areas, in which the first light-emitting layers are formed, second emission areas, in which the second light-emitting layers are formed, and third emission areas, in which the third light-emitting layers are formed,
the first light-emitting layers emit blue light, the second light-emitting layers emit red light, and the third light-emitting layers emit green light.

13. The method of claim 12, wherein

the first emission areas are repeatedly arranged and spaced apart from one another in the first direction, and the second emission areas and the third emission areas are disposed in the second direction with respect to the first emission areas and are alternately arranged in the first direction.

14. The method of claim 12 or 13, wherein the second emission areas and the third emission areas overlap with the first emission areas in the second direction, in a plan view.

15. The method of claim 12, 13, or 14, wherein at least two of the second emission areas and at least two of the third emission areas overlap with one of the first emission areas in the second direction, in a plan view.

# FIG. 1

# FIG. 2

300

DA

MA

NDA

SBA

310

320

330

DR2

DR1

DR3

# FIG. 3

# FIG. 4

ER

ED1

210 220 230

TFE3
TFE2 } TFE
TFE1

PDL } EML

180 } TFTL

CNE2

CNE1

170
160
150
140
130

BF2

SUB2

BF1

SUB1

ACT2

S2 GE2 D2

ST

ACT1

S1 GE1 D1 BML

DT

SEM1: ACT1, S1, D1
SEM2: ACT2, S2, D2

**FIG. 5**

# FIG. 6

**FIG. 7**

# FIG. 8

**FIG. 9**

## FIG. 10

## FIG. 11

**FIG. 12**

**FIG. 13**

**FIG. 14**

# FIG. 15

# FIG. 16

OR

RP1

601

OR

611

Q3

θ1

PL

PS

612

602

Q3'

DR3

DR2

DR1

# FIG. 17

OR

RP2

601

OR

611

Q4

θ2

PL

PS

612

602

Q4'

DR3

DR2

DR1

# FIG. 18

520C

544

OG

DR2

DR1

DR3

**FIG. 19**

RP2          544

Q5'

OG

RP1

Q6          Q6'

Q5

DR2

DR3 → DR1

# FIG. 20

# FIG. 21

# FIG. 22

# FIG. 23

# FIG. 24

# FIG. 25

# FIG. 26

# FIG. 27

# FIG. 28

OG  RP2  OG  520C

544

RP1

OG  OG

DR2
↑
⊙→ DR1
DR3

# FIG. 29

# FIG. 30

S100
FABRICATE FIRST, SECOND,
AND THIRD MASK ASSEMBLIES

S200
DEPOSIT FIRST LIGHT-EMITTING LAYERS
ON TARGET SUBSTRATE USING
FIRST MASK ASSEMBLY

S300
DEPOSIT SECOND LIGHT-EMITTING LAYERS
ON TARGET SUBSTRATE USING
SECOND MASK ASSEMBLY

S400
DEPOSIT THIRD LIGHT-EMITTING LAYERS
ON TARGET SUBSTRATE USING
THIRD MASK ASSEMBLY

# FIG. 31

TS

NDA

DA

# FIG. 32

500

510  520A

TS

440

DM

# FIG. 33

# FIG. 34

# FIG. 35